(19) Europäisches Patentamt
European Patent Office
Office européen des brevets

(11) **EP 4 263 712 B1**

(12) **EUROPEAN PATENT SPECIFICATION**


(45) Date of publication and mention of the grant of the patent:
**09.10.2024 Bulletin 2024/41**

(21) Application number: **21852002.1**

(22) Date of filing: **15.12.2021**

(51) International Patent Classification (IPC):
***C08L 83/06*** *(2006.01)* ***C09D 183/06*** *(2006.01)*

(52) Cooperative Patent Classification (CPC):
(C-Sets available)
**C09D 183/06; C08L 83/06;** C08G 77/20; C08G 77/70 (Cont.)

(86) International application number:
**PCT/US2021/063527**

(87) International publication number:
**WO 2022/132906 (23.06.2022 Gazette 2022/25)**


(54) **METHOD OF PREPARING FILM AND COMPOSITION THEREFOR**

VERFAHREN ZUR HERSTELLUNG VON FILM UND ZUSAMMENSETZUNG DAFÜR

PROCEDE DE PREPARATION D’UN FILM ET COMPOSITION DE CELUI-CI


(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.12.2020 US 202063126727 P**

(43) Date of publication of application:
**25.10.2023 Bulletin 2023/43**



(73) Proprietor: **Dow Silicones Corporation**
**Midland, MI 48686-0994 (US)**

(72) Inventor: **FU, Peng-Fei**
**Midland, Michigan 48686-0994 (US)**

(74) Representative: **Murgitroyd & Company**
**165-169 Scotland Street**
**Glasgow G5 8PL (GB)**



(56) References cited:
**WO-A1-2008/088523**
**US-A- 4 568 566**
**US-B2- 8 618 233**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08L 83/06, C08K 5/04;**
**C09D 183/06, C08K 5/04**

## Description

CROSS-REFERENCE TO RELATED APPLICATIONS

This application claims priority to and all advantages of U.S. Provisional Patent Application No. 63/126,727 filed on 17 December 2020.

TECHNICAL FIELD

The subject disclosure generally relates to a method of preparing a film and, more specifically, to a method of preparing a film via irradiation and to a composition therefor.

BACKGROUND

Silicone resins are known in the art and utilized in various end use applications. Silicone resins typically include three-dimensional networks attributable to the presence of T siloxy units ($R^0SiO_{3/2}$) and/or Q siloxy units ($SiO_{4/2}$), where $R^0$ is a substituent. Properties of silicone resins differ depending on, among other things, their cross-link densities and molar fractions of siloxy units. Increasing the cross-link density generally results in a greater hardness and/or rigidity.

Silicone resins are often functionalized for purposes of formulating curable compositions. Curable compositions including functionalized silicone resins can then be cured, e.g. through a reaction with a reactive component (e.g. a crosslinker) and/or via exposure to a curing condition. For example, curable compositions including functionalized silicone resins may be cured via heat, moisture, irradiation, etc. depending on the functionalized silicone resins utilized.

Conventional silicone resins are solids at room temperature, or 25 °C. As such, conventional curable compositions including conventional silicone resins are typically solvent-borne, as solvent is needed to dissolve conventional silicone resins. The solvent is typically driven or volatilized prior to or during end use applications of the conventional curable compositions. However, removal of solvent adds processing steps and cost in connection with end use applications of conventional curable compositions utilizing such solid silicone resins. In addition, removal of solvent generally requires elevated temperatures, which are unsuitable for certain end use applications of silicone resins (e.g. when disposed on certain electronic devices).

UV curing of silicone compositions is often utilized in preparing films and coatings where it is desirable to cure in the absence of heat. However, if the silicone compositions include conventional silicone resins, the silicone compositions are generally solvent-borne, as described above, which still necessitates elevated temperatures, even if not for curing. If the silicone compositions are solvent free, the silicone compositions are typically based on linear and/or partially branched organopolysiloxanes that have low viscosities and are liquids at room temperatures. However, use of linear organopolysiloxanes results in a film or coating having a lesser crosslink density as compared to films formed via silicone resins, which reduces hardness and other properties of the film or coating, which can be undesirable. US 4 568 566 discloses curable silicone resin containing (meth)acrylate radicals and four or more siloxy units used as coating.WO2008088523A1 and US8618233B2 concern dual curing silicone polymers useful in electronics applications, for example, as conformal coatings, sealants, and adhesives.

Further still, certain substrates on which films or coatings are formed can have complex geometries or surface characteristics that result in shadow areas that are difficult to cure via UV radiation. Thus, it's often desirable to utilize dual cure systems that can be cured via both UV radiation and moisture (or another curing mechanism that does not necessitate elevated temperatures). However, conventional silicone resins do not include sufficient functional group content to effect both UV and moisture curing, which again necessitates use of linear organopolysiloxanes.

BRIEF SUMMARY

Disclosed is a method of preparing a film, which may alternatively be referred to as a coating. The method comprises applying a composition on a substrate to give an uncured layer. The method further comprises irradiating the uncured layer to give the film. The composition comprises: (a) a polysiloxane resin, (b) a photoinitiator, and optionally (c) a functional diluent as in the appended claims. The (a) polysiloxane resin comprises the following siloxy units: $[R_3SiO_{1/2}]$, $[(OZ)_qSiO_{(4-q)/2}]$ and at least one of $[(OZ)_tR^{MA}SiO_{(3-t)/2}]$ or $[(OZ)_dRR^{MA}SiO_{(2-d)/2}]$; where: each R is independently a substituted or unsubstituted hydrocarbyl group, each $R^{MA}$ is independently an acryloxy functional group, each Z is independently H or an alkyl group, subscript q is in each occurrence a number selected from a range of 0-3, subscript t is in each occurrence a number selected from a range of 0-2, and subscript d is in each occurrence a number selected from a range of 0-1, with the proviso that the average concentration of OZ groups is at least 12 mole-percent relative to moles of silicon atoms in the (a) polysiloxane resin.

The composition for preparing the film, and the film formed via the method, are also disclosed.

DETAILED DESCRIPTION

A method of preparing a film with a composition, and the composition for preparing the film, are disclosed and described below. The composition is curable via exposure to UV radiation, and can also be dual cured via moisture (i.e., condensation) in combination with irradiation. In certain embodiments, it is desirable to form the film via dual curing of the composition to increase a crosslink density within the film and/or to cure in areas difficult to reach via irradiation (e.g. shadow areas). In other embodiments, as described below, the film may be formed via irradiation only (without moisture curing). For example, though not limited to this particular end use application, the film formed via the method has excellent physical properties for use as a protective and/or conformal coating. Depending on a shape of a substrate on which the film is formed, dual curing the film can ensure that the film is fully cured even in areas that are difficult to penetrate or reach with irradiation (e.g. due to dimensions and/or surface characteristics of the substrate).

The composition comprises: (a) a polysiloxane resin, (b) a photoinitiator, and optionally (c) a functional diluent and (d) a condensation catalyst.

The (a) polysiloxane resin comprises the following siloxy units: $[R_3SiO_{1/2}]$, $[(OZ)_qSiO_{(4-q)/2}]$ and at least one of $[(OZ)_tR^{MA}SiO_{(3-t)/2}]$ or $[(OZ)_dRR^{MA}SiO_{(2-d)/2}]$. In one embodiment, the (a) polysiloxane resin includes both $[(OZ)_tR^{MA}SiO_{(3-t)/2}]$ and $[(OZ)_dRR^{MA}SiO_{(2-d)/2}]$ siloxy units. In other embodiments, the (a) polysiloxane is free from one of these types of siloxy units but includes the other type of siloxy units. In the (a) polysiloxane resin, each R is independently a substituted or unsubstituted hydrocarbyl group, each $R^{MA}$ is independently an acryloxy functional group, each Z is independently H or an alkyl group, subscript q is in each occurrence a number selected from a range of 0-3, subscript t is in each occurrence a number selected from a range of 0-2, and subscript d is in each occurrence a number selected from a range of 0-1, with the proviso that the average concentration of OZ groups is at least 12 mole-percent relative to moles of silicon atoms in the (a) polysiloxane resin.

As introduced above, each R is an independently selected hydrocarbyl group. In general, hydrocarbyl groups suitable for R may independently be linear, branched, cyclic, or combinations thereof. Cyclic hydrocarbyl groups encompass aryl groups as well as saturated or non-conjugated cyclic groups. Cyclic hydrocarbyl groups may independently be monocyclic or polycyclic. Linear and branched hydrocarbyl groups may independently be saturated or unsaturated. One example of a combination of a linear and cyclic hydrocarbyl group is an aralkyl group. General examples of hydrocarbyl groups include alkyl groups, aryl groups, alkenyl groups, halocarbon groups, and the like, as well as derivatives, modifications, and combinations thereof. Examples of suitable alkyl groups include methyl, ethyl, propyl (e.g. iso-propyl and/or n-propyl), butyl (e.g. isobutyl, n-butyl, tert-butyl, and/or sec-butyl), pentyl (e.g. isopentyl, neopentyl, and/or tert-pentyl), hexyl, hexadecyl, octadecyl, as well as branched saturated hydrocarbon groups having from 6 to 18 carbon atoms. Examples of suitable non-conjugated cyclic groups include cyclobutyl, cyclohexyl, and cycyloheptyl groups. Examples of suitable aryl groups include phenyl, tolyl, xylyl, naphthyl, benzyl, and dimethyl phenyl. Examples of suitable alkenyl groups include vinyl, allyl, propenyl, isopropenyl, butenyl, isobutenyl, pentenyl, heptenyl, hexenyl, hexadecenyl, octadecenyl and cyclohexenyl groups. Examples of suitable monovalent halogenated hydrocarbon groups (i.e., halocarbon groups) include halogenated alkyl groups, aryl groups, and combinations thereof. Examples of halogenated alkyl groups include the alkyl groups described above where one or more hydrogen atoms is replaced with a halogen atom such as F or Cl. Specific examples of halogenated alkyl groups include fluoromethyl, 2-fluoropropyl, 3,3,3-trifluoropropyl, 4,4,4-trifluorobutyl, 4,4,4,3,3-pentafluorobutyl, 5,5,5,4,4,3,3-heptafluoropentyl, 6,6,6,5,5,4,4,3,3-nonafluorohexyl, and 8,8,8,7,7-pentafluorooctyl, 2,2-difluorocyclopropyl, 2,3-difluorocyclobutyl, 3,4-difluorocyclohexyl, and 3,4-difluoro-5-methylcycloheptyl, chloromethyl, chloropropyl, 2-dichlorocyclopropyl, and 2,3-dichlorocyclopentyl groups, as well as derivatives thereof. Examples of halogenated aryl groups include the aryl groups described above where one or more hydrogen atoms is replaced with a halogen atom, such as For Cl. Specific examples of halogenated aryl groups include chlorobenzyl and fluorobenzyl groups.

In certain embodiments, each R is free of aliphatic unsaturation (i.e., each R is not an alkenyl or alkynyl group). In these or other embodiments, each R is independently an alkyl group or an aryl group. In a specific embodiment, each R is independently selected from alkyl groups having from 1 to 32, alternatively from 1 to 28, alternatively from 1 to 24, alternatively from 1 to 20, alternatively from 1 to 16, alternatively from 1 to 12, alternatively from 1 to 8, alternatively from 1 to 4, alternatively 1, carbon atoms.

Each $R^{MA}$ is independently an acryloxy functional group. Typically, each $R^{MA}$ independently has the formula:

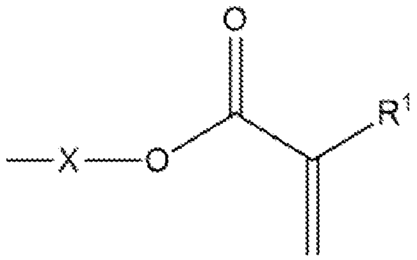

,

wherein X is a covalent bond or a divalent linking group, and $R^1$ is H or an alkyl group. Suitable alkyl groups for $R^1$ are disclosed above for R. In certain embodiments, $R^1$ is H, such that $R^{MA}$ may be defined as an acrylate group. In other embodiments, $R^1$ is an alkyl group, such that $R^{MA}$ may be defined as an alkylacrylate group. In specific embodiments, $R^1$ is methyl, such that $R^{MA}$ may be defined as a methacrylate group. In one embodiment, X is a covalent bond. In other embodiments, X is a divalent linking group. The divalent linking group is not limited and may be organic or may be, for example, a siloxy moiety. Typically, when X is the divalent linking group, X is a divalent hydrocarbon group. Suitable hydrocarbon groups for the divalent linking group may be substituted or unsubstituted, and linear, branched, and/or cyclic. Typically, however, when divalent linking group is a divalent hydrocarbon group, X is a linear unsubstituted hydrocarbon group including from 1 to 12, alternatively from 1 to 10, alternatively from 1 to 8, alternatively from 1 to 6, alternatively from 1 to 4, carbon atoms.

Each Z is independently H or an alkyl group, and thus each OZ moiety is independently in each occurrence a hydroxyl or alkoxyl group. In specific embodiments, each OZ is independently in each occurrence selected from hydroxyl, methoxy, and ethoxy. Increasing the OZ content generally increases the fluidity of the (a) polysiloxane resin (lowers its viscosity) and increases the rate (decreases time required) for the composition to moisture cure to form a skin when the composition is moisture cured. Increasing OZ content also tends to increase glass adhesion. Therefore, higher OZ content can be desirable to enhance those characteristics. In some applications, thermal stability of the (a) polysiloxane resin may be important in which an upper limit to the OZ content will become important because thermal stability of the (a) polysiloxane resin tends to decrease with increasing OZ content. It can be desirable for the (a) polysiloxane resin to have a 5% weight-loss temperature (by thermal gravimetric analysis (TGA)) that is above 150 degrees Celsius (°C). To achieve such a thermal stability it can be desirable for the of OZ content to be, for example, 80 mol% or less, alternatively 60 mol% or less, alternatively 50 mol% or less, alternatively 40 mol% or less, alternatively 30 mol% or less, alternatively 20 mol% or less. In these or other embodiments, the (a) polysiloxane resin has a content of SiOZ moieties of from 12 to 80, alternatively from 15 to 70, alternatively from 15 to 60, alternatively from 15 to 50, alternatively from 15 to 40, alternatively from 15 to 30, percent based on the total number of moles of Si in each molecule. Herein, OZ content is relative to moles of silicon atoms in the polysiloxane resin. Conventional silicone resins have much lower OZ content, especially conventional silicone resins including functional groups, such as acryloxy functional groups. For example, such functional groups are generally imparted to conventional silicone when forming the conventional silicone resin (e.g. via a functionalized silane). Formation of such conventional silicone resins often involves condensation of OZ groups to give siloxane bonds in the resulting silicone resin such that the OZ content of the silicone resin is reduced.

SiOZ content can be determined or measured using $^{29}$Si nuclear magnetic resonance spectroscopy ($^{29}$Si NMR). $^{29}$Si NMR can be conducted, for example, using a Varian XL-400 spectrometer. Reference chemical shifts to internal solvent resonance and are reported relative to tetramethylsilane. Each siloxane unit in the resin shows up in a unique position. Integration under the areas of the peaks allows calculation of the concentration of OZ groups relative to silicon atoms. Peaks in the spectrum are labeled as to which siloxane unit they correspond to, with the labels being as follows:

M = $R_3SiO_{1/2}$
D1 = $R_2(OZ)SiO_{1/2}$
D2 = $R_2SiO_{2/2}$
T1= $R(OZ)_2SiO_{1/2}$
T2= $R(OZ)SiO_{2/2}$
T3= $RSiO_{3/2}$
Q1= $(OZ)_3SiO_{1/2}$
Q2= $(OZ)_2SiO_{2/2}$
Q3= $(OZ)SiO_{3/2}$
Q4= $SiO_{4/2}$

OZ content relative to silicon atoms as a mol% can be calculated with the following formula with the label for each peak in the formula corresponding to the integrated area under the peak corresponding to the label:

$$\text{OZ content (mol\%)} = 100 \times \left( \frac{(D1+2xT1+T2+3xQ1+2xQ2+Q3)}{(M+D1+D2+T1+T2+T3+Q1+Q2+Q3+Q4)} \right)$$

In certain embodiments, the (a) polysiloxane consists of $[R_3SiO_{1/2}]$, $[(OZ)_qSiO_{(4-q)/2}]$ and at least one of $[(OZ)_tR^{MA}SiO_{(3-t)/2}]$ or $[(OZ)_dRR^{MA}SiO_{(2-d)/2}]$ siloxy units. In other embodiments, the (a) polysiloxane can further comprise $R_2SiO_{2/2}$units (D type units) and/or $RSiO_{3/2}$ (T type units). It can be desirable to include D type units to impart linear characteristic to the (a) polysiloxane resin, which generally decreases hardness of the film as the concentration of the D type unit increases. In other embodiments, it may be desirable to increase hardness of the film. In such embodiments, it may be desirable to keep the concentration of D type units in the (a) polysiloxane resin to 10 mol% or less, preferably 5 mol% or less, even more preferably 2 mol% or less, one mol% or less or even 0.5 mol% or less on average with respect to total moles of siloxy units. The (a) polysiloxane resin can be free of D type siloxane units to achieve greatest hardness in the film formed from the composition.

In specific embodiments, the (a) polysiloxane resin has the average formula:

$$[W]_a[X]_b[Y]_c[Z]_d,$$

where subscript a is from greater than 0 to 0.5; subscript b is from 0 to 0.5; subscript c is from greater than 0 to 0.5; and subscript d is from greater than 0 to 0.6; with the proviso that a+b+c+d=1. Subscripts a, b, c and d are mole fractions of the W, X, Y, and Z units in the (a) polysiloxane resin.

In the average formula above for the (a) polysiloxane resin, [W], [X], [Y], and [Z] are utilized in lieu of the more common nomenclature [M], [D], [T] and [Q]. As understood in the art, M siloxy units include one siloxane bond (i.e., -O-Si-); D siloxy units include two siloxane bonds; T siloxy units include three siloxane bonds; and Q siloxy units include four siloxane bonds.

However, for purposes of this disclosure, [W] indicates siloxy units including one -Si-O-bond, which may be a siloxane bond or a precursor thereof, but is typically a siloxane bond. Precursors of siloxane bonds are -Si-OZ bonds, where Z is independently selected and defined above. Silanol groups and alkoxy groups can hydrolyze and/or condense to give siloxane bonds and are typically inherently present in most silicone resins. Such precursors of siloxane bonds can be minimized by bodying of silicone resins, which results in further condensation with water as a by-product. Thus, for purposes of this disclosure, [W] indicates $[R_3SiO_{1/2}]$, where each R is an independently selected and defined above.

Further, for purposes of this disclosure, [X] indicates siloxy units including two -Si-O-bonds, which may independently be siloxane bonds or a precursor thereof. Thus, for purposes of this disclosure, [X] is $[R_2SiO_{1/2}(OZ)]_{b'}[R_2SiO_{2/2}]_{b''}[RR^{MA}SiO_{2/2}]_{b'''}[R^{MA}SiO_{1/2}(OZ)]_{b''''}$, where each R and $R^{MA}$ is independently selected and defined above; $0 \le b' \le b$; $0 \le b'' \le b$; $0 \le b''' \le b$; $0 \le b'''' \le b$; with the proviso that b'+b"+b‴+b″″ corresponds to b in the average formula above; and wherein each Z is independently selected and defined above. Subscripts b', b", b‴, and b″″ indicate the relative mole fraction of [X] siloxy units indicated by each subscript, respectively, with regard to the overall average formula of the (a) polysiloxane resin. In [X] siloxy units indicated by b' and b″″, there is one siloxane bond and one Si-OZ bond, and in the [X] siloxy units indicated by subscript b" and b‴, there are two siloxane bonds.

Further, for purposes of this disclosure, [Y] indicates siloxy units including three -Si-O-bonds, which may independently be siloxane bonds or a precursor thereof. Thus, for purposes of this disclosure, [Y] is $[R^{MA}Si(OZ)_{c'}O_{3-c'/2}]$ and/or $[RSi(OZ)_{c'}O_{3-c'/2}]$, where each $R^{MA}$ and each R is independently selected and defined above; c' is an integer from 0 to 2 and is independently selected in each Y siloxy unit indicated by subscript c in the (a) polysiloxane resin. Thus, [Y] can indicate any combination of the following siloxy units: $[R^{MA}SiO_{3/2}]$, $[R^{MA}Si(OZ)_1O_{2/2}]$, $[R^{MA}Si(OZ)_2O_{1/2}]$, $[RSiO_{3/2}]$, $[RSi(OZ)_1O_{2/2}]$, and/or $[RSi(OZ)_2O_{1/2}]$. In certain embodiments, the (a) polysiloxane is free of $[RSiO_{3/2}]$, $[RSi(OZ)_1O_{2/2}]$, and $[RSi(OZ)_2O_{1/2}]$ siloxy units. If the siloxy units indicated by Y are R rather than $R^{MA}$, then $R^{MA}$ groups are typically present in the X siloxy units noted above.

Further, for purposes of this disclosure, [Z] indicates siloxy units including four -Si-O-bonds, which may independently be siloxane bonds or a precursor thereof. Thus, for purposes of this disclosure, [Z] is $[Si(OZ)_{d'}O_{4-d'/2}]$, where each Z is independently selected and defined above, and subscript d' is an integer from 0 to 3 and is independently selected in each siloxy unit indicated by subscript c in the (a) polysiloxane resin. The (a) polysiloxane resin can include siloxy units indicated by subscript d where d' is 0, d' is 1, d' is 2, and d' is 3. The siloxy units represented by [Z] can have one, two, three, or four siloxane bonds, with the balance being Si-OZ moieties. Thus, [Z] can indicate any combination of the following siloxy units: $[SiO_{4/2}]$, $[Si(OZ)O_{3/2}]$, $[Si(OZ)_2O_{2/2}]$, and/or $[Si(OZ)_3O_{1/2}]$.

In certain embodiments, subscript a is from greater than zero to 0.5. In specific embodiments, subscript a is from 0.10 to 0.50, alternatively from 0.15 to 0.40, alternatively from 0.2 to 0.4, alternatively from 0.2 to 0.35, alternatively from 0.25 to 0.30, alternatively from 0.25 to 0.35, alternatively from 0.28 to 0.33.

In these or other embodiments, subscript b is from greater than zero to 0.5. In specific embodiments, subscript b is from 0.01 to 0.40, alternatively from 0.02 to 0.30, alternatively from 0.03 to 0.20, alternatively from 0.04 to 0.15, alternatively from 0.05 to 0.1. In other embodiments subscript b is 0. Subscripts b', b", b‴ and b⁗ define the relative amounts of particular siloxy units represented by [X].

In these or other embodiments, subscript c is greater than 0, for example from greater than zero to 0.5, alternatively from 0.05 to 0.4, alternatively from 0.1 to 0.3.

In these or other embodiments, subscript d is from greater than zero to 0.6. In specific embodiments, subscript d is from 0.35 to 0.60, alternatively from 0.40 to 0.60, alternatively from 0.40 to 0.55, alternatively from 0.45 to 0.55, alternatively from 0.45 to 0.53.

In various embodiments, the (a) polysiloxane resin has a weight-average molecular weight of from 1,000 to 100,000, alternatively from 1,000 to 50,000, alternatively from 1,000 to 10,000. Molecular weight may be measured via gel permeation chromatography (GPC) relative to polystyrene standards. In these or other embodiments, the (a) polysiloxane resin has a viscosity at 25 °C of from 10 to 500,000, alternatively from 10 to 250,000, alternatively from 10 to 100,000, cP. Viscosity may be measured at 25 °C via a Brookfield LV DV-E viscometer with a spindle selected as appropriate to the viscosity of the (a) polysiloxane resin, as understood in the art. The viscosity and the molecular weight of the (a) polysiloxane resin can be controlled when preparing the (a) polysiloxane resin. In other embodiments, the (a) polysiloxane resin is a gum at 25 °C, in which case the (a) polysiloxane resin may not have a viscosity that can be readily measured at 25 °C, but which still has flowable characteristics and is considered a liquid for purposes of this disclosure.

In certain embodiments the (a) polysiloxane resin is a liquid at 25 °C in the absence of any solvent. Generally, silicone resins and in particular silicate resins are solids at 25 °C due to their three-dimensional networked structure. In view of the difficulty of processing solid silicone resins, silicone resins are typically dissolved in solvent and utilized as a silicone resin composition, which comprises or consists of a solid silicone resin dissolved in a solvent, e.g. an aliphatic or aromatic hydrocarbon solvent. In this way, the silicone resin compositions are liquid at 25 °C or room temperature, which allows easier processing of the silicone resin compositions. For example, silicone resin compositions can be combined with other components or compositions for various end use applications in liquid form. Similarly, conventional silicone resins, which are solid at 25 °C in the absence of any solvent, are not readily miscible with liquid silicones. This means that when preparing silicone compositions, conventional silicone resins, which are solid at 25 °C, cannot be readily mixed or solubilized with liquid silicones, e.g. liquid organopolysiloxanes, in the absent of organic solvent. Thus, when conventional silicone resins are utilized in silicone compositions, organic solvents are typically required for purposes of forming the silicone compositions and subsequently volatilized, either in composition form or when curing.

However, one drawback of silicone compositions is that the solvent is typically removed in end use applications. For example, when silicone compositions are utilized to form films, coatings or articles, the solvent is typically removed when forming such films or articles. This requires additional processing steps, as well as energy and related cost, for removal of solvent, e.g. via volatilization.

In contrast, the inventive (a) polysiloxane resin is typically a liquid at 25 °C in the absence of any solvent. Thus, the (a) polysiloxane resin being a liquid at 25 °C is not attributable to the presence of any solvent, e.g. organic solvent, unlike conventional silicone resins. The (a) polysiloxane resin consists of (a) polysiloxane resin without any solvent or carrier vehicle. Further still, not only is the (a) polysiloxane resin a liquid at 25 °C in the absence of any solvent, but the (a) polysiloxane resin is miscible with other liquid organopolysiloxanes, which allows for the direct incorporation of the (a) polysiloxane resin in various silicone compositions in solvent-less form, but in terms of preparation and end composition.

By "liquid", it is meant that the (a) polysiloxane resin is flowable at 25 °C and/or has a viscosity that is measurable at 25 °C, in the absence of any solvent. Typically, the viscosity of the (a) polysiloxane resin is measurable at 25 °C via a Brookfield LV DV-E viscometer with a spindle selected as appropriate to the viscosity of the (a) polysiloxane resin. The viscosity of the (a) polysiloxane resin may vary, particularly based on the content of M, D, T and/or Q siloxy units present therein, as described below. However, for purposes of this disclosure, the (a) polysiloxane resin can be in the form of a gum, as gums still have flowable characteristics, even if gums do not have viscosities that can be readily measured at 25 °C.

In various embodiments, the (a) polysiloxane resin is prepared from an MQ resin, where M designates ($R^0SiO_{3/2}$) siloxy units, and Q designates ($SiO_{4/2}$) siloxy units, where $R^0$ designates a silicon-bonded substituent. Such MQ resins are known in the art and are often in solid (e.g. powder or flake) form unless disposed in a solvent. However, typically in the nomenclature utilized in the art, M siloxy units are trimethylsiloxy units, whereas the MQ resin may include hydrocarbyl groups other than methyl groups. Typically, however, the M siloxy units of the MQ resin are trimethylsiloxy units.

The MQ resin may have formula $M_ZQ$, where subscript z refers to the molar ratio of M siloxy units to Q siloxy units when the number of moles of Q siloxy units is normalized to 1. The greater the value of z, the lesser the crosslink density of the MQ resin. The inverse is also true, because as the value of z decreases, the number of M siloxy units decreases, and thus more Q siloxy units are networked without termination via an M siloxy unit. The fact that the formula for the MQ resin normalizes the content of Q siloxy units to 1 does not imply that the MQ resin includes only one Q unit.

Typically, the MQ resin includes a plurality of Q siloxy units clustered or bonded together. The MQ resin may include, in certain embodiments, up to 4, alternatively up to 3, alternatively up to 2, weight percent of hydroxyl groups. In these or other embodiments, the MQ resin includes from >1 to <12, alternatively from >8 to < 11.5, mol% SiOH groups based on the total number of siloxy units. The (a) polysiloxane resin includes a higher mol% of SiOZ groups than the content of SiOH groups in the MQ resin.

In specific embodiments, subscript z is <1, e.g. subscript z is from 0.05 to 0.99, alternatively from 0.10 to 0.95, alternatively from 0.15 to 0.90, alternatively from 0.25 to 0.85, alternatively from 0.40 to 0.80. In these embodiments, on a molar basis, there are more Q siloxy units than M siloxy units in the MQ resin. However, z may be >1 in other embodiments, e.g. from >1 to 6, alternatively from >1 to 5, alternatively from >1 to 4, alternatively from >1 to 3, alternatively from >1 to 2.

In specific embodiments, to prepare the (a) polysiloxane resin from the MQ resin, the MQ resin is reacted with a silane component comprising a silane compound in the presence of a catalyst. The silane compound typically has the formula $R^{MA}R_xSi(OR^2)_{3-x}$, where $R^{MA}$ and R are defined above, each $R^2$ is an independently selected alkyl group, and subscript x is 0 or 1. The silane compound includes a silicon-bonded acryloxy group (indicated by $R^{MA}$) and two or three silicon-bonded alkoxy groups. When subscript x is zero, the silane compound includes three silicon-bonded alkoxy groups. When x is one, the silane compound includes two silicon-bonded alkoxy groups. The silane compound is utilized to impart acryloxy functionality in the (a) polysiloxane resin via $R^{MA}$. The silicon-bonded alkoxy groups can be independently selected and typically have from 1 to 10, alternatively from 1 to 8, alternatively from 1 to 6, alternatively from 1 to 4, alternatively 1 or 2, alternatively 1, carbon atom. For example, the silicon-bonded alkoxy groups can be methoxy, ethoxy, propoxy, butoxy, etc. When subscript x is 1, the silane compound is incorporated into the (a) polysiloxane resin as siloxy groups indicated by $[RR^{MA}SiO_{2/2}]$. When subscript x is 0, the silane compound is incorporated into the (a) polysiloxane resin as siloxy groups indicated by $[R^{MA}SiO_{3/2}]$.

Combinations of different silane compounds may be utilized in the silane component. For example, different species of the silane compound may be utilized together in the silane component. In addition, in certain embodiments, the silane component further comprises a second silane compound having the formula $R_2Si(OR^2)_2$, where R and $R^2$ are each independently selected and defined above. In these embodiments, the second silane compound is incorporated into the (a) polysiloxane resin as siloxy groups indicated by $[R_2SiO_{1/2}(OZ)]$ and/or $[R_2SiO_{2/2}]$. In these or other embodiments, the silane component can further comprise a third silane compound having the formula $RSi(OR^2)_3$, where R and $R^2$ are each independently selected and defined above. In these embodiments, the third silane compound is incorporated into the (a) polysiloxane resin as siloxy groups indicated by $[RSiO_{1/2}(OZ)_2]$, $[RSiO_{2/2}(OZ)]$, and/or $[RSiO_{3/2}]$.

In the method of preparing the (a) polysiloxane resin, the catalyst typically cleaves siloxane bonds of the MQ resin, typically between M and Q siloxy units, to give SiOZ groups, where Z is defined above. The silane compounds of the silane component can hydrolyze and condense with the SiOZ groups to be incorporated therein. Both the cleaved siloxy bonds and inclusion of linear siloxy units attributable to the silane compound results in the (a) polysiloxane resin being liquid at 25 °C in the absence of any solvent.

The relative amount of the silane component (utilized as compared to the MQ resin is a function of the desired subscript b and subscript c in the (a) polysiloxane resin. One of skill in the art understands how to selectively control such content in view of the description herein, including the Examples which follow this detailed description.

The MQ resin and the silane compound are reacted in the presence of a catalyst. Typically, the catalyst is an acid or a base such that the reaction between the MQ resin and the silane component is either an acid catalyzed or a base catalyzed reaction. Typically, the reaction is base catalyzed. As such, in certain embodiments, the catalyst may be selected from the group of strong acid catalysts, strong base catalysts, and combinations thereof. The strong acid catalyst may be trifluoromethane sulfonic acid and the like. The catalyst is typically a strong base catalyst. Typically, the strong base catalyst is KOH, although other base catalysts, such as a phosphazene base catalyst, may be utilized.

The phosphazene catalyst, which generally includes at least one -(N=P<)- unit (i.e., a phosphazene unit) and is usually an oligomer having up to 10 such phosphazene units, for example having an average of from 1.5 up to 5 phosphazene units. The phosphazene catalyst may be, for example, a halophosphazene, such as a chlorophosphazene (phosphonitrile chloride), an oxygen-containing halophosphazene, an ionic derivative of a phosphazene such as a phosphazenium salt, particularly an ionic derivative of a phosphonitrile halide such as a perchlorooligophosphazenium salt, or a partially hydrolyzed form thereof.

In specific embodiments, the catalyst comprises a phosphazene base catalyst. The phosphazene base catalyst may be any known in the art but typically has the following chemical formula:

$$((R^4_2N)_3P{=}N)_p(R^4_2N)_{3-p}P{=}NR^4$$

wherein each $R^4$ is independently selected from the group of a hydrogen atom, R, and combinations thereof, and p is an integer from 1 to 3. If $R^4$ is a R, then $R^4$ is typically an alkyl group having from 1 to 20, alternatively from 1 to 10, alternatively from 1 to 4, carbon atoms. The two $R^4$ groups in the any $(R^4_2N)$ moiety may be bonded to the same nitrogen

(N) atom and linked to complete a heterocyclic ring preferably having 5 or 6 members.

Alternatively, the phosphazene base catalyst may be a salt and have one of the following alternative chemical formulas:

$$[((R^4{}_2N)_3P{=}N)p(R^4{}_2N)_{3-p}P{=}N(H)R^4]^+[A^-];$$

or

$$[((R^4{}_2N)_3P{=}N)_s(R^4{}_2N)_{4-s}P]^+[A^-]$$

wherein each $R^4$ is independently selected and defined above, subscript p is defined above, subscript s is an integer from 1 to 4, and [A] is an anion and is typically selected from the group of fluoride, hydroxide, silanolate, alkoxide, carbonate and bicarbonate. In one embodiment, the phosphazene base is an aminophosphazenium hydroxide.

In certain embodiments, the MQ resin and the silane component are reacted at an elevated temperature, e.g. from 75 to 125 °C, in the presence of a solvent. Suitable solvents may be hydrocarbons. Suitable hydrocarbons include aromatic hydrocarbons such as benzene, toluene, or xylene; and/or aliphatic hydrocarbons such as heptane, hexane, or octane. Alternatively, the solvent may be a halogenated hydrocarbon such as dichloromethane, 1,1,1-trichloroethane or methylene chloride. A neutralizing agent, such as acetic acid, may be utilized to neutralize the catalyst after the reaction. One of skill in the art can readily determine a catalytic quantity of the catalyst to be utilized, which is a function of its selection and reaction conditions. The resulting (a) polysiloxane resin can be isolated or recovered from the reaction product via conventional techniques, e.g. stripping or other volatilization techniques.

As introduced above, composition further includes (b) a photoinitiator. The (b) photoinitiator catalyzed the reaction of the $R^{MA}$ groups in the (a) polysiloxane resin upon exposure to UV radiation. The (b) photoinitiator is not limited and can be selected from any known free radical type photo-initiator effective for promoting crosslinking reactions. Examples of the (b) photoinitiator include diethoxyacetophenone (DEAP), benzoin methyl ether, benzoin ethyl ether, benzoin isopropyl ether, diethoxyxanthone, chloro-thioxanthone, azo-bisisobutyronitrile, N-methyl diethanolaminebenzophenone 4,4'-bis(dimethylamino)benzophenone, diethoxyacetophenone, 2,2-dimethoxy-1,2-diphenylethan-1-one, 1 -hydroxycyclohexyl-phenyl-ketone, 2-hydroxy-2-methyl-1 -phenylpropan-1-one, 2-methyl-1-[4-(methylthio)phenyl]-2-morpholinopropan-1 -one, 1 -[4-(2-hydroxyethoxy)phenyl]-2-hydroxy-2-methyl-propan-1-one, 2-benzyl-2-dimethylamino-1-(4-morpholinophenyl)butan-1-one, bis(2,4,6-trimethylbenzoyl)phenylphosphine oxide, 2-hydroxy-2-methyl-1-phenyl-propan-1-one, 2-dimethylamino-2-(4-methyl-benzyl)-1-(4-morpholin-4-yl-phenyl)-butan-1-one, and combinations thereof.

The content of the (b) photoinitiator is an effective amount for photo-cure of the composition. In various embodiments, the (b) photoinitiator is present in the composition in an amount of from about 0.01 to about 5 parts by mass, alternatively from about 0.1 to about 5 parts by mass, alternatively from about 0.1 to about 3 parts by mass, per 100 parts by the total mass of the composition.

In certain embodiments, the composition further comprises (c) a functional diluent. The (c) functional diluent typically includes a functional group selected from epoxy groups and acryloxy groups. Examples of epoxy groups include a 3-glycidoxypropyl group, a 4-glycidoxybutyl group, or similar glycidoxyalkyl groups; a 2-(3,4-epoxycyclohexyl)ethyl group, a 3-(3,4-epoxycyclohexyl)propyl group, or similar epoxycyclohexylalkyl groups; and a 4-oxiranylbutyl group, an 8-oxiranyloctyl group, or similar oxiranylalkyl groups. One example of an acryloxy group is a 3-methacryloxypropyl group.

In certain embodiments, the (c) functional diluent comprises a polyfunctional acrylate. The polyfunctional acrylate includes two or more acryloxy functional groups. Examples of polyfunctional acrylates include (alkyl)acrylic compounds having two or more acryloxy or methacryloyl groups, such as trimethylolpropane di(meth)acrylate, trimethylolpropane tri(meth)acrylate, polyoxyethylene-modified trimethylolpropane tri(meth)acrylate, polyoxypropylene-modified trimethylolpropane tri(meth)acrylate, polyoxyethylene/polyoxypropylene-modified trimethylolpropane tri(meth)acrylate, dimethyloltricyclodecane di(meth)acrylate, pentaerythritol tri(meth)acrylate, pentaerythritol tetra(meth)acrylate, ethylene glycol di(meth)acrylate, tetraethylene glycol di(meth)acrylate, phenylethylene glycol di(meth)acrylate, polyethylene glycol) di(meth)acrylate, polypropylene glycol) di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, o-xylylene di(meth)acrylate, m-xylylene di(meth)acrylate, p-xylylene di(meth)acrylate, tris(2-hydroxyethyl)isocyanurate tri(meth)acrylate, tris(acryloyloxy) isocyanurate, bis(hydroxymethyl)tricyclodecane di(meth)acrylate, dipentaerythritol penta(meth)acrylate, dipentaerythritol hexa(meth)acrylate, polyoxyethylene-modified 2,2-bis(4-((meth)acryloxy)phenyl)propane, polyoxypropylene-modified 2,2-bis(4-((meth)acryloxy)phenyl)propane, polyoxyethylene/polyoxypropylene-modified 2,2-bis(4-((meth)acryloxy)phenyl)propane, dipentaerythritol penta-/hexa-acrylate, and combinations thereof.

It is to be appreciated that the (alkyl)acrylic compounds above are described in terms of (meth)acrylate species only for brevity, and that one of skill in the art will readily understand that other alkyl and/or hydrido versions of such

compounds may equally be utilized. For example, one of skill in the art will understand that the monomer "2-ethylhexyl (meth)acrylate" listed above exemplifies both 2-ethylhexyl (meth)acrylate as well as 2-ethylhexyl acrylate. Likewise, while the acrylic monomers are described generally as propenoates (i.e., $\alpha,\beta$-unsaturated esters) in the examples above, it is to be appreciated that the that the term "acrylate" used in these descriptions may equally refer to an acid, salt, and/or conjugate base of the esters exemplified. For example, one of skill in the art will understand that the monomer "methyl acrylate" listed above exemplifies the methyl ester of acrylic acid, as well as acrylic acid, acrylate salts (e.g. sodium acrylate), etc. Furthermore, multifunctional derivatives/variations of the acrylic monomers described above may also be utilized. For example, the monomers "ethyl (meth)acrylate" listed above exemplifies functionalized-derivatives, such as substituted ethyl (meth)acrylates and ethyl acrylates (e.g. hydroxyethyl (meth) acrylate and hydroxyethyl acrylate, respectively).

In these or other embodiments, the (c) functional diluent can be selected from lower alkyl acrylates such as methyl acrylate, ethyl acrylate, n-propyl acrylate, and isopropyl acrylate; lower alkyl methacrylates such as methyl methacrylate, ethyl methacrylate, n-propyl methacrylate, and isopropyl methacrylate; higher acrylates such as n-butyl acrylate, isobutyl acrylate, tert-butyl acrylate, n-hexyl acrylate, cyclohexyl acrylate, 2-ethylhexyl acrylate, octyl acrylate, lauryl acrylate, and stearyl acrylate; higher methacrylates such as n-butyl methacrylate, isobutyl methacrylate, tert-butyl methacrylate, n-hexyl methacrylate, cyclohexyl methacrylate, 2-ethylhexyl methacrylate, octyl methacrylate, lauryl methacrylate, and stearyl methacrylate; the vinyl esters of lower aliphatic acids, such as vinyl acetate and vinyl propionate; the vinyl esters of higher aliphatic acids, such as vinyl butyrate, vinyl caproate, vinyl 2-ethylhexanoate, vinyl laurate, and vinyl stearate; aromatic vinyl monomers such as styrene, vinyl toluene, benzyl acrylate, benzyl methacrylate, phenoxyethyl acrylate, phenoxyethyl methacrylate, and vinyl pyrrolidone; amino-functional vinyl monomers such as dimethylaminoethyl acrylate, dimethylaminoethyl methacrylate, diethylaminoethyl acrylate, and diethylaminoethyl methacrylate; amide-functional vinyl monomers such as acrylamide, N-methylolacrylamide, N-methoxymethylacrylamide, isobutoxymethoxyacrylamide, N,N-dimethylacrylamide, methacrylamide, N-methylolmethacrylamide, N-methoxymethylmethacrylamide, isobutoxymethoxymethacrylamide, and N,N-dimethylmethacrylamide; hydroxyl-functional vinyl monomers such as 2-hydroxyethyl acrylate, 2-hydroxybutyl acrylate, 2-hydroxypropyl acrylate, 2-hydroxyethyl methacrylate, 2-hydroxybutyl methacrylate, and 2-hydroxypropyl methacrylate; fluorinated vinyl monomers such as trifluoropropyl acrylate, perfluorobutylethyl acrylate, perfluorooctylethyl acrylate, trifluoropropyl methacrylate, perfluorobutylethyl methacrylate, and perfluorooctylethyl methacrylate; epoxy-functional vinyl monomers such as glycidyl acrylate, 3,4-epoxycyclohexylmethyl acrylate, glycidyl methacrylate, and 3,4-epoxycyclohexylmethyl methacrylate; ether linkage-containing vinyl monomers such as tetrahydrofurfuryl acrylate, butoxyethyl acrylate, ethoxydiethylene glycol acrylate, polyethylene glycol acrylate, polypropylene glycol monoacrylate, hydroxybutyl vinyl ether, cetyl vinyl ether, 2-ethylhexyl vinyl ether, tetrahydrofurfuryl methacrylate, butoxyethyl methacrylate, ethoxydiethylene glycol methacrylate, polyethylene glycol methacrylate, polypropylene glycol monomethacrylate; alkoxysilanes that contain a radically polymerizable unsaturated group, such as

- $CH_2=CHCOOC_3H_6Si(OCH_3)_3$,
- $CH_2=C(CH_3)COOC_3H_6Si(OCH_3)_3$,
- $CH_2=C(CH_3)COOC_3H_6Si(CH_3)(OCH_3)_2$,
- $CH_2=C(CH_3)COOC_3H_6Si(CH_3)_2OCH_3$,
- $CH_2=C(CH_3)COOC_2H_4OC_3H_6Si(OCH_3)_3$,
- $CH_2=C(CH_3)COOC_{12}H_{24}Si(OCH_3)_3$,
- $CH_2=CHOC_3H_6Si(CH_3)(OC_2H_5)_2$,
- $CH_2=CHSi(OCH_3)_3$,
- $CH_2=CHSi(OC_2H_5)_3$, and
- $CH_2=CHSi(C_4H_9)(OC_4H_9)_2$;

unsaturated group-functionalized silicone compounds such as organopolysiloxane (branched or straight-chain) bearing an acryl or methacryl group at a single terminal and polydimethylsiloxane bearing a styryl group at a single terminal; butadiene; vinyl chloride; vinylidene chloride; acrylonitrile and methacrylonitrile; dibutyl fumarate; maleic anhydride;

dodecylsuccinic anhydride; radically polymerizable unsaturated carboxylic acids, such as acrylic acid, methacrylic acid, itaconic acid, crotonic acid, fumaric acid, and maleic acid, as well as their alkali metal salts, ammonium salts, and organic amine salts; radically polymerizable unsaturated monomers that contain a sulfonic acid residue, e.g., styrenesulfonic acid, as well as their alkali metal salts, ammonium salts, and organic amine salts; quaternary ammonium salts that are derived from (meth)acrylic acid, such as 2-hydroxy-3-methacryloxypropyltrimethylammonium chloride; and the methacrylate esters of alcohols that contain a tertiary amine group, such as the diethylamine ester of methacrylic acid, as well as the quaternary ammonium salts thereof. In certain embodiments, preferred among the preceding are acrylate ester monomers, methacrylate ester monomers, and styrene monomers.

Also usable as the (c) functional diluent are multifunctional vinyl monomers, as can be exemplified by acryloyl- or methacryloyl-functional monomers such as trimethylolpropane triacrylate, pentaerythritol triacrylate, ethylene glycol diacrylate, tetraethylene glycol diacrylate, polyethylene glycol diacrylate, 1,4-butanediol diacrylate, 1,6-hexanediol diacrylate, neopentyl glycol diacrylate, trimethylolpropane trioxyethylacrylate, tris(2-hydroxyethyl)isocyanurate diacrylate, tris(2-hydroxyethyl)isocyanurate triacrylate, trimethylolpropane trimethacrylate, pentaerythritol trimethacrylate, ethylene glycol dimethacrylate, tetraethylene glycol dimethacrylate, polyethylene glycol dimethacrylate, 1,4-butanediol dimethacrylate, 1,6-hexanediol dimethacrylate, neopentyl glycol dimethacrylate, trimethylolpropane trioxyethylmethacrylate, tris(2-hydroxyethyl)isocyanurate dimethacrylate, tris(2-hydroxyethyl)isocyanurate trimethacrylate, the diacrylates and dimethacrylates of diols that are the adducts of ethylene oxide or propylene oxide on bisphenol A, and the diacrylates and dimethacrylates of diols that are the adducts of ethylene oxide or propylene oxide on hydrogenated bisphenol A. Usable multifunctional vinyl monomers can also be exemplified by triethylene glycol divinyl ether, and divinylbenzene.

Alternatively or in addition, the (c) functional diluent can comprise or organopolysiloxane having two or more acryloxy-functional groups. Typically, the acryloxy-functional groups are terminal in the organopolysiloxane, but may be in pendant positions. The organopolysiloxane is typically linear and may have a degree of polymerization of from 1 to 1,000, alternatively from 1 to 500. For example, the organopolysiloxane may be a polydimethylsiloxane terminated in methacrylate functional groups (e.g. 3-acryloxypropyl groups).

In these or other embodiments, the (c) functional diluent can be selected from silane compounds, including 3-glycidoxypropyltrimethoxysilane, 3-glycidoxypropyltriethoxysilane, (epoxycyclohexyl)ethyldimethoxysilane, (epoxycyclohexyl)ethyldiethoxysilane, 3-methacryloyloxypropyl trimethoxysilane, 3-methacryloyloxypropyl triethoxysilane, 3-acryloyloxypropyl trimethoxysilane, 3-acryloyloxypropyl triethoxysilane, 3-methacryloxypropyltriacetoxysilane, 2-(3,4-epoxycyclohexylethyl)trimethoxysilane, and combinations thereof.

If utilized, the (c) functional diluent can comprise a blend of different functional diluents, and is typically present in the composition in an amount of from greater than 0 to 40, alternatively from greater than 0 to 30, alternatively from greater than 0 to 20, alternatively from 5 to 15, weight percent based on the total weight of the composition.

In certain embodiments, the composition further comprises (d) a condensation catalyst. The (d) condensation catalyst is utilized when it is desirable to dual cure the composition in forming the film, e.g. curing via both irradiation and moisture. The moisture for purposes of moisture curing can be ambient moisture attributable to relative humidity, i.e., no moisture need to actively introduced to effect moisture curing. However, if desired, moisture can be selectively controlled, e.g. by increasing relative humidity, to influence moisture cure rate.

As described above, the (a) polysiloxane resin includes both acryloxy functionality and significant SiOZ content. In contrast, conventional silicone resins that include acryloxy functionality typically include much lesser SiOZ content, and are solids at room temperature in the absence of a solvent. However, the combination of acryloxy-functionality and significant SiOZ content in the (a) polysiloxane resin allows for dual curing via irradiation and moisture. The SiOZ content contributes to greater crosslink density from moisture curing than would otherwise be possible with conventional silicone resins having lesser SiOZ content. These benefits are in addition to those associated with the (a) polysiloxane resin being a liquid at room temperature.

Specific examples of the (d) condensation catalyst include organo-metal catalysts including titanium compounds such as tetra(isopropoxy)titanium, tetra(n-butoxy)titanium, tetra(t-butoxy)titanium, di(isopropoxy)bis(ethylacetoacetate)titanium, di(isopropoxy)bis(methylacetoacetate)titanium, di(isopropoxy)bis(acetylacetonate)titanium, and the like; zirconium compounds such as tetra(isopropoxy)zirconium, tetra(n-butoxy)zirconium, tetra(t-butoxy)zirconium, di(isopropoxy)bis(ethylacetoacetate)zirconium, di(isopropoxy)bis(methylacetoacetate)zirconium, di(isopropoxy)bis(acetylacetonate)zirconium, and the like; tin compounds such as dimethyltin dineodecanoate, dibutyltin dilaurate, dibutyltin dioctoates, and the like; and stannous octoate, and the like.

When utilized, the content of the (d) condensation catalyst is in effective amount for moisture cure. In various embodiments, the (d) condensation catalyst is present in an amount of from about 0.01 to about 10 parts by mass, optionally of from about 0.05 to about 10 parts by mass, or optionally of from about 0.05 to about 5 parts by mass, per 100 parts by the total mass of the composition.

The composition may optionally further include an additive component. The additive component may be selected from the group of plasticizers, surface modifiers, waxes, reinforcing agents, dyes, pigments, colorants, fillers, flame retardants, mold release agents, anti-oxidants, compatibility agents, ultraviolet light stabilizers, thixotropic agents, anti-aging agents, lubricants, coupling agents, solvents or carrier vehicles, rheology promoters, adhesion promoters, thickeners, and combinations thereof.

One or more of the additives can be present as any suitable weight percent (wt.%) of the composition, such as 0.1 wt.% to 15 wt.%, 0.5 wt.% to 5 wt.%, or 0.1 wt.% or less, 1 wt.%, 2, 3, 4, 5, 6, 7, 8, 9, 10, 11, 12, 13, 14, or 15 wt.% or more of the composition. One of skill in the art can readily determine a suitable amount of additive depending, for example, on the type of additive and the desired outcome. Certain optional additives are described in greater detail below.

Suitable carrier vehicles may be considered solvents when capable of solubilizing the components of the composition. Suitable carrier vehicles include silicones, both linear and cyclic, organic oils, organic solvents, water (in the event the composition is utilized as an oil in water emulsion), and mixtures of these. Specific examples or organic solvents include hydrocarbons, such as aromatic hydrocarbons including benzene, toluene, or xylene, as well as aliphatic hydrocarbons, such as heptane, hexane, or octane.

In specific embodiments, the composition is substantially free from, alternatively free from, carrier vehicles and/or solvents. By substantially free, it is meant that the composition comprises less than 5, alternatively less than 4, alternatively less than 3, alternatively less than 2, alternatively less than 1, alternatively 0, wt.% of carrier vehicles and/or solvents based on the total weight of the composition. For the purposes of this disclosure, the (c) functional diluent, which may optionally be included in the composition, is not considered a carrier vehicle or solvent, even though use of the (c) functional diluent may lower viscosity of the composition. In one specific embodiment, the composition is free from organic solvents.

The composition may include one or more fillers. The fillers may be one or more reinforcing fillers, non-reinforcing fillers, or mixtures thereof. Examples of finely divided, reinforcing fillers include high surface area fumed and precipitated silicas including rice hull ash and to a degree calcium carbonate. Fumed silica can include types that are surface-functionalized, such as hydrophilic or hydrophobic, and are available from Cabot Corporation under the CAB-O-SIL tradename. Examples of finely divided non-reinforcing fillers include crushed quartz, diatomaceous earths, barium sulphate, iron oxide, titanium dioxide and carbon black, talc, and wollastonite. Other fillers which might be used alone or in addition to the above include carbon nanotubes, e.g. multiwall carbon nanotubes aluminite, hollow glass spheres, calcium sulphate (anhydrite), gypsum, calcium sulphate, magnesium carbonate, clays such as kaolin, aluminum trihydroxide, magnesium hydroxide (brucite), graphite, copper carbonate, e.g. malachite, nickel carbonate, e.g. zarachite, barium carbonate, e.g. witherite and/or strontium carbonate e.g. strontianite. Further alternative fillers include aluminum oxide, silicates from the group consisting of olivine group; garnet group; aluminosilicates; ring silicates; chain silicates; and sheet silicates. In certain embodiments, the composition includes at least one filler comprising hollow particles, e.g. hollow spheres. Fillers, when utilized, can be used in the composition in amounts of from 0.01 to 50, alternatively from 0.05 to 40, alternatively from 0.1 to 35, wt.% based on the total weight of the composition. In addition, fumed silica, if utilized, can be used in amounts from 0.01 to 5, alternatively from 0.05 to 3, alternatively from 0.1 to 2.5, alternatively from 0.2 to 2.2 wt.% based on the total weight of the composition.

The filler, if utilized, may optionally be surface treated with a treating agent. Treating agents and treating methods are understood in the art. The surface treatment of the filler(s) is typically performed, for example with a fatty acid or a fatty acid ester such as a stearate, or with organosilanes, organosiloxanes, or organosilazanes such as hexaalkyl disilazane or short chain siloxane diols. Generally the surface treatment renders the filler(s) hydrophobic and therefore easier to handle and obtain a homogeneous mixture with the other components in the composition. Silanes such as $R^4_eSi(OR^5)_{4-e}$ where $R^4$ is a substituted or unsubstituted monovalent hydrocarbon group of 6 to 20 carbon atoms, for example, alkyl groups such as hexyl, octyl, dodecyl, tetradecyl, hexadecyl, and octadecyl, and aralkyl groups such as benzyl and phenylethyl, $R^5$ is an alkyl group of 1 to 6 carbon atoms, and subscript e is equal to 1, 2 or 3, may also be utilized as the treating agent for fillers.

In various embodiments, the composition further comprises an adhesion-imparting agent. The adhesion-imparting agent can improve adhesion of the foam to a base material being contacted during curing. In certain embodiments, the adhesion-imparting agent is selected from organosilicon compounds having at least one alkoxy group bonded to a silicon atom in a molecule. This alkoxy group is exemplified by a methoxy group, an ethoxy group, a propoxy group, a butoxy group, and a methoxyethoxy group. Moreover, non-alkoxy groups bonded to a silicon atom of this organosilicon compound are exemplified by substituted or non-substituted monovalent hydrocarbon groups such as alkyl groups, alkenyl groups, aryl groups, aralkyl groups, halogenated alkyl groups and the like; epoxy group-containing monovalent organic groups such as a 3-glycidoxypropyl group, a 4-glycidoxybutyl group, or similar glycidoxyalkyl groups; a 2-(3,4-epoxycyclohexyl)ethyl group, a 3-(3,4-epoxycyclohexyl)propyl group, or similar epoxycyclohexylalkyl groups; and a 4-oxiranylbutyl group, an 8-oxiranyloctyl group, or similar oxiranylalkyl groups; acrylic group-containing monovalent organic groups such as a 3-methacryloxypropyl group and the like; and a hydrogen atom.

This organosilicon compound generally has a silicon-bonded alkenyl group or silicon-bonded hydrogen atom. Moreover, due to the ability to impart good adhesion with respect to various types of base materials, this organosilicon compound generally has at least one epoxy group-containing monovalent organic group in a molecule. This type of

organosilicon compound is exemplified by organosilane compounds, organosiloxane oligomers and alkyl silicates. Molecular structure of the organosiloxane oligomer or alkyl silicate is exemplified by a linear chain structure, partially branched linear chain structure, branched chain structure, ring-shaped structure, and net-shaped structure. A linear chain structure, branched chain structure, and net-shaped structure are typical. This type of organosilicon compound is exemplified by silane compounds such as 3-glycidoxypropyltrimethoxysilane, 2-(3,4-epoxycyclohexyl)-ethyltrimethoxysilane, 3-methacryloxy propyltrimethoxysilane, and the like; siloxane compounds having at least one silicon-bonded alkenyl group or silicon-bonded hydrogen atom, and at least one silicon-bonded alkoxy group in a molecule; mixtures of a silane compound or siloxane compound having at least one silicon-bonded alkoxy group and a siloxane compound having at least one silicon-bonded hydroxyl group and at least one silicon-bonded alkenyl group in the molecule; and methyl polysilicate, ethyl polysilicate, and epoxy group-containing ethyl polysilicate.

In certain embodiments, the composition consists essentially of, alternatively consists of, the (a) polysiloxane resin, the (b) photoinitiator, and optionally the (c) functional diluent, optionally the (d) condensation catalyst, and optionally a filler.

The composition typically as a viscosity of from greater than 0 to 50,000, alternatively from 100 to 20,000, alternatively from 200 to 10,000, alternatively from 200 to 5,000, alternatively from 200 to 1,000, cp at 25 °C, even in the absence of any solvents or carriers. Thus, the composition is flowable at room temperature and can form uniform coatings and films.

The composition may be used in diverse end use applications. For example, the composition can be utilized to form films having excellent physical properties, including scratch resistance. The films can be utilized in electronic applications (e.g. as protective or conformal coatings), in waveguides, and as protective coatings (e.g. for windows or displays or other substrates susceptible to scratching). The film can also be patterned, e.g. through use of selective curing with a photomask.

As introduced above, a method of preparing a film with the composition comprises applying the composition on a substrate to give an uncured layer. The method further comprises irradiating the uncured layer to give the film. When the composition includes the (d) condensation catalyst, the method may further comprise moisture curing the uncured layer and/or the film.

The composition may be applied (i.e., disposed or dispensed) on the substrate in any suitable manner. Typically, the composition is applied in wet form via a wet coating technique. The composition may be applied by i) spin coating; ii) brush coating; iii) drop coating; iv) spray coating; v) dip coating; vi) roll coating; vii) flow coating; viii) slot coating; ix) gravure coating; x) Meyer bar coating; or xi) a combination of any two or more of i) to x). Typically, disposing the composition on the substrate results in a wet deposit or uncured layer on the substrate, which is subsequently cured to give the film on the substrate.

The substrate is not limited and may be any substrate. The film may be separable from the substrate or may be physically and/or chemically bonded to the substrate depending on its selection. The substrate may optionally have a continuous or non-continuous shape, size, dimension, surface roughness, and other characteristics.

The substrate can be an electronic article or component. In other embodiments, the substrate can comprise glass. Alternatively still, the substrate may comprise a plastic, which maybe a thermosetting and/or thermoplastic. However, the substrate may alternatively be or comprise metal, ceramics, fiberglass, cellulose (e.g. paper), wood, cardboard, paperboard, a silicone, or polymeric materials, or a combination thereof.

Specific examples of suitable substrates include paper substrates such as Kraft paper, polyethylene coated Kraft paper (PEK coated paper), thermal paper, and regular papers; polymeric substrates such polyamides (PA); polyesters such as polyethylene terephthalates (PET), polybutylene terephthalates (PET), polytrimethylene terephthalates (PTT), polyethylene naphthalates (PEN), and liquid crystalline polyesters; polyolefins such as polyethylenes (PE), polypropylenes (PP), and polybutylenes; styrenic resins; polyoxymethylenes (POM); polycarbonates (PC); polymethylenemethacrylates (PMMA); polyvinyl chlorides (PVC); polyphenylene sulfides (PPS); polyphenylene ethers (PPE); polyimides (PI); polyamideimides (PAI); polyetherimides (PEI); polysulfones (PSU); polyethersulfones; polyketones (PK); polyetherketones; polyvinyl alcohols (PVA); polyetheretherketones (PEEK); polyetherketoneketones (PEKK); polyarylates (PAR); polyethernitriles (PEN); phenolic resins; phenoxy resins; celluloses such as triacetylcellulose, diacetylcellulose, and cellophane; fluorinated resins, such as polytetrafluoroethylenes; thermoplastic elastomers, such as polystyrene types, polyolefin types, polyurethane types, polyester types, polyamide types, polybutadiene types, polyisoprene types, and fluoro types; and copolymers, and combinations thereof.

The wet deposit or uncured layer is cured via exposure to irradiation, typically UV radiation. Useful UV radiation sources include conventional mercury-vapor lamps designed to emit ultraviolet energy in various ultraviolet wavelength bands, LED curing lamps, etc. For example, useful radiation wavelength ranges include 200 to 400 nm. UV cure is generally effected in the range of 40 milliwatts/$cm^2$ ("$mW/cm^2$") to 30,000 $mW/cm^2$, such as in the range of about 70 $mW/cm^2$ to about 300 $mW/cm^2$. In certain embodiments, irradiation is carried out in an inert atmosphere, e.g. under nitrogen.

If desired, the film formed via irradiating the uncured layer can be patterned. For example, in these embodiments,

a photomask is typically utilized in the selective curing of a target portion of the uncured layer. Photomasks generally have a defined pattern for transmitting UV radiation and a complementary pattern for blocking transmission of UV radiation. For example, the photomask includes portions that allow for transmission of UV radiation, and portions that block transmission of UV radiation, such that the defined pattern can be transferred or copied via selectively curing. The portions of the photomask that allow for transmission of UV radiation are aligned with the target portion of the uncured layer, and the complementary portions of the photomask that block transmission of UV radiation are aligned with non-target portions of the uncured layer. Such a method may be referred to as photolithography. The target portions of the uncured layer are cured to give cured regions, and the non-target portions of the uncured layer are not cured to give uncured regions.

The uncured regions of the film that remain through use of a photomask may be etched via a wet method, e.g. with an organic solvent or aqueous base, alternatively via a dry method (e.g. with plasma or reactive ions). Typically, the uncured regions are etched or removed with a solvent, such as butyl acetate, alcohols, ketones, aromatic hydrocarbons, alkanes, ethers, esters, and combinations thereof. Etching or removing the uncured regions results in only the cured regions, which may have 100% pattern retentivity.

The composition comprises the (d) condensation catalyst and the method further comprises moisture curing the composition (and/or the film formed from irradiation), moisture curing may be effected without any proactive steps. The composition (and/or the film formed from irradiation) can be moisture cured prior to, during, or after curing via irradiation. In one embodiment, moisture curing is effective after curing via irradiation by removing the inert atmosphere and exposing the film formed from irradiation to moisture, e.g. relative humidity. Sequential curing steps are typically utilized when irradiation is carried out in an inert atmosphere, which often does not include ambient moisture to effect moisture curing.

In certain embodiments, the film can be exposed to a post-bake, e.g. exposed to elevated temperature for a period of time. The elevated temperature is typically from 80 to 140, alternatively from 100 to 120, °C.

A coated substrate, which comprises the film formed from the composition on the substrate, may have varying dimensions, including relative thicknesses of the film and the substrate. The film has a thickness that may vary depending upon its end use application. The film may have a thickness of greater than 0 to 4,000 μm, alternatively greater than 0 to 3,000 μm, alternatively greater than 0 to 2,000 μm, alternatively greater than 0 to 1,000 μm, alternatively greater than 0 to 500 μm, alternatively greater than 0 to 250 μm. However, other thicknesses are contemplated, e.g. 0.1 to 200 μm. For example, the thickness of the film may be 0.2 to 175 μm; alternatively 0.5 to 150 μm; alternatively 0.75 to 100 μm; alternatively 1 to 75 μm; alternatively 2 to 60 μm; alternatively 3 to 50 μm; and alternatively 4 to 40 μm. Alternatively, when the substrate is plastic, the film may have a thickness of greater than 0 to 200, alternatively greater than 0 to 150 μm, and alternatively greater than 0 to 100 μm.

If desired, the film may be subjected to further processing depending upon its end use application. For example, the film may be subjected to oxide deposition (*e.g.* $SiO_2$ deposition), resist deposition and patterning, etching, chemical, corona, or plasma stripping, metallization, or metal deposition. Such further processing techniques are generally known. Such deposition may be chemical vapor deposition (including low-pressure chemical vapor deposition, plasma-enhanced chemical vapor deposition, and plasma-assisted chemical vapor deposition), physical vapor deposition, or other vacuum deposition techniques. Many such further processing techniques involve elevated temperatures, particularly vacuum deposition, for which the film is well suited in view of its excellent thermal stability. Depending on an end use of the film, however, the film may be utilized with such further processing.

The following examples are intended to illustrate the invention and are not to be viewed in any way as limiting to the scope of the invention. Certain components utilized in the Examples are set forth in Table 1 below, followed by characterization and evaluation procedures also used in the Examples.

Table 1 - Components

| Component | Chemical Description |
|---|---|
| MQ Resin | A solid resin powder of formula $((CH_3)_3SiO_{1/2})_{43.2}(HOSiO_{3/2})_{11.5}(SiO_{4/2})_{45.3}$ |
| Silane Compound (1) | (3-methacryloxypropyl)trimethoxysilane |
| Silane Compound (2) | Dimethyldimethoxysilane |
| Silane Compound (3) | (3-methacrloxypropyl)methyldimethoxysilane |
| Catalyst | KOH |
| Neutralizing Agent | Acetic Acid |
| Solvent (1) | Toluene ($C_7H_8$) |

(continued)

| Component | Chemical Description |
|---|---|
| W | $(CH_3)_3SiO_{1/2}$ |
| $X^{MA}$ | $[MeR^{MA}SiO_{1/2}(OZ)]$ and $[MeR^{MA}SiO_{2/2}]$ |
| X | $[Me_2SiO_{1/2}(OZ)]$ and $[Me_2SiO_{2/2}]$ |
| Y | $[MeSiO_{3/2}]$, $[MeSiO_{2/2}(OZ)]$ and $[MeSiO_{1/2}(OZ)_2]$ |
| γMA | $[R^{MA}SiO_{3/2}]$, $[R^{MA}SiO_{2/2}(OZ)]$ and $[R^{MA}SiO_{1/2}(OZ)_2]$ |
| Z | $[SiO_{1/2}(OZ)_3]$, $[SiO_{2/2}(OZ)_2]$, $[SiO_{3/2}(OZ)]$, and $[SiO_{4/2}]$ |
| OZ | OH or OMe |
| Photoinitiator (1) | 2,2-dimethoxy-1 ,2-diphenylethan-1-one |
| Photoinitiator (2) | 2-hydroxy-2-methyl-1-phenyl-propan-1-one |
| Photoinitiator (3) | 2-dimethylamino-2-(4-methyl-benzyl)-1-(4-morpholin-4-yl-phenyl)-butan-1-one |
| Condensation Catalyst | Tetraisopropyl titanate |
| Functional Diluent (1) | Tri(propylene glycol) diacrylate |
| Functional Diluent (2) | Trimethylolpropane triacrylate |
| Functional Diluent (3) | Dipentaerythritol penta-/hexa-acrylate |
| Functional Diluent (4) | Methacylpropyl capped polydimethylsiloxane having a viscosity at 25 °C of 50-90 cst |
| Filler | Colloidal silica (30 wt.% in methyl ethyl ketone) |

Nuclear Magnetic Resonance Spectroscopy (NMR)

Nuclear magnetic resonance (NMR) spectra are obtained on a Varian EX-400 5 MHz Mercury spectrometer with $CDCl_3$ solvent. Chemical shifts for $^1$H-NMR, $^{13}$C-NMR, and $^{29}$Si-NMR spectra are referenced to internal solvent resonance and are reported relative to tetramethylsilane.

Gel Permeation Chromatography (GPC)

Gel permeation chromatography (GPC) analysis is conducted on an Agilent 1260 Infinity II chromatograph equipped with a triple detector composed of a differential refractometer, an online differential viscometer, a low angle light scattering (LALS: 15° and 90° angles of detection), and a column (2 PL Gel Mixed C, Varian). Toluene (HPLC grade, Biosolve) is used as mobile phase, at a flow rate of 1 mL/min.

Dynamic Viscosity (DV)

Dynamic viscosity (DV) was measured with a Brookfield DV-III Ultra Programmable Rheometer equipped with a CPA-52Z spindle, using a sample volume of 0.5 mL, at a temperature of 25 °C.

SiOZ Content

The content of SiOZ moieties can be calculated via $^{29}$Si-NMR. In particular, the molar content of the following siloxy units in each Polysiloxane resin are determined:

M = $R'_3SiO_{1/2}$
D1 = $R'_2(OZ)SiO_{1/2}$
D2 = $R'_2SiO_{2/2}$
T1= $R'(OZ)_2SiO_{1/2}$
T2= $R'(OZ)SiO_{2/2}$
T3= $R'SiO_{3/2}$

Q1= $(OZ)_3SiO_{1/2}$
Q2= $(OZ)_2SiO_{2/2}$
Q3= $(OZ)SiO_{3/2}$
Q4= $SiO_{4/2}$

OZ content relative to silicon atoms as a mol% can be calculated with the following formula with the label for each peak in the formula corresponding to the integrated area under the peak corresponding to the label:

$$\text{OZ content (mol\%)} = 100 \times \left( \frac{(D1+2xT1+T2+3xQ1+2xQ2+Q3)}{(M+D1+D2+T1+T2+T3+Q1+Q2+Q3+Q4)} \right)$$

R' in the Examples is methyl or an acryloxy functional group.

Preparation Example 1: Polysiloxane Resin (A1)

800 g of Solvent (1), followed by 500 g of MQ Resin, were disposed in a 3L flask equipped with a magnetic stir-bar. 340 grams of Silane Compound (1) and 0.82 grams of Catalyst were disposed in the flask. The contents of the flask were stirred at reflux (70 °C) under nitrogen, with progress of the reaction in the flask being monitored via GC. After 4 hours, the contents of the flask were cooled to 23 °C, and 1.23 grams of Neutralizing Agent were disposed in the flask to neutralize the Catalyst. The reaction product in the flask was filtered through a 1 micron filter to give a clear and viscous liquid. Polysiloxane Resin (A1) was isolated from the reaction product through removal of volatiles via roto-vap. Polysiloxane Resin (A1) was analyzed and is characterized below in Table 2.

Preparation Example 2: Polysiloxane Resin (A2)

800 g of Solvent (1), followed by 500 g of MQ Resin, were disposed in a 3L flask equipped with a magnetic stir-bar. 340 grams of Silane Compound (1) and 0.82 grams of Catalyst were disposed in the flask. The contents of the flask were stirred at reflux (70 °C) under nitrogen, with progress of the reaction in the flask being monitored via GC. After it was determined that Silane Compound (1) was consumed (via GC), 18.4 grams of water and 20 grams of methanol were disposed in the flask, and a Dean-Stark head was attached thereto. The contents of the flask were stirred and heated to 95 °C while collecting volatiles and replacing the volume of volatiles collected with Solvent (1). After reaching 95 °C, the contents of the flask were cooled to 23 °C, and 1.23 grams of Neutralizing Agent were disposed in the flask to neutralize the Catalyst. The reaction product in the flask was filtered through a 1 micron filter to give a clear and viscous liquid. Polysiloxane Resin (A2) was isolated from the reaction product through removal of volatiles via roto-vap. Polysiloxane Resin (A2) was analyzed and is characterized below in Table 2.

Preparation Example 3: Polysiloxane Resin (A3)

800 g of Solvent (1), followed by 500 g of MQ Resin, were disposed in a 3L flask equipped with a magnetic stir-bar. 340 grams of Silane Compound (1) and 0.82 grams of Catalyst were disposed in the flask. The contents of the flask were stirred at reflux (70 °C) under nitrogen, with progress of the reaction in the flask being monitored via GC. After it was determined that Silane Compound (1) was consumed (via GC), 18.4 grams of water and 20 grams of methanol were disposed in the flask, and a Dean-Stark head was attached thereto. The contents of the flask were stirred and heated to 102 °C while collecting volatiles and replacing the volume of volatiles collected with Solvent (1). After reaching 102 °C, the contents of the flask were cooled to 23 °C, and 1.23 grams of Neutralizing Agent were disposed in the flask to neutralize the Catalyst. The reaction product in the flask was filtered through a 1 micron filter to give a clear and viscous liquid. Polysiloxane Resin (A3) was isolated from the reaction product through removal of volatiles via roto-vap. Polysiloxane Resin (A3) was analyzed and is characterized below in Table 2.

Example 4: Polysiloxane Resin (A4)

800 g of Solvent (1), followed by 506 g of MQ Resin, were disposed in a 3L flask equipped with a magnetic stir-bar. 340 grams of Silane Compound (1) and 0.82 grams of Catalyst were disposed in the flask. The contents of the flask were stirred at reflux (70 °C) under nitrogen, with progress of the reaction in the flask being monitored via GC. After 5.5 hours, the contents of the flask were cooled to 23 °C, and 1.23 grams of Neutralizing Agent were disposed in the

flask to neutralize the Catalyst. The reaction product in the flask was filtered through a 1 micron filter to give a clear and viscous liquid. Polysiloxane Resin (A4) was isolated from the reaction product through removal of volatiles via roto-vap. Polysiloxane Resin (A4) was analyzed and is characterized below in Table 2.

Example 5: Polysiloxane Resin (A5)

500 g of Solvent (1), followed by 300 g of MQ Resin, were disposed in a 2L flask equipped with a magnetic stir-bar. 152 grams of Silane Compound (1), 49 grams of Silane Compound (2), and 0.30 grams of Catalyst were disposed in the flask. The contents of the flask were stirred at reflux (70 °C) under nitrogen, with progress of the reaction in the flask being monitored via GC. After 6 hours, the contents of the flask were cooled to 23 °C, and 0.45 grams of Neutralizing Agent were disposed in the flask to neutralize the Catalyst. The reaction product in the flask was filtered through a 1 micron filter to give a clear and viscous liquid. Polysiloxane Resin (A5) was isolated from the reaction product through removal of volatiles via roto-vap. Polysiloxane Resin (A5) was analyzed and is characterized below in Table 2.

Example 6: Polysiloxane Resin (A6)

500 g of Solvent (1), followed by 300 g of MQ Resin, were disposed in a 2L flask equipped with a magnetic stir-bar. 152 grams of Silane Compound (1), 49 grams of Silane Compound (2), and 0.30 grams of Catalyst were disposed in the flask. The contents of the flask were stirred at reflux (70 °C) under nitrogen, with progress of the reaction in the flask being monitored via GC. After it was determined that Silane Compounds 1 and 2 were consumed (via GC), 11 grams of water and 20 grams of methanol were disposed in the flask, and a Dean-Stark head was attached thereto. The contents of the flask were stirred and heated to 105 °C while collecting volatiles and replacing the volume of volatiles collected with Solvent (1). After reaching 105 °C, the contents of the flask were cooled to 23 °C, and 0.45 grams of Neutralizing Agent were disposed in the flask to neutralize the Catalyst. The reaction product in the flask was filtered through a 1 micron filter to give a clear and viscous liquid. Polysiloxane Resin (A6) was isolated from the reaction product through removal of volatiles via roto-vap. Polysiloxane Resin (A6) was analyzed and is characterized below in Table 2.

Example 7: Polysiloxane Resin (A7)

200 g of Solvent (1), followed by 100 g of MQ Resin, were disposed in a 1L flask equipped with a magnetic stir-bar. 50.7 grams of Silane Compound (1), 31.6 grams of Silane Compound (3), and 0.10 grams of Catalyst were disposed in the flask. The contents of the flask were stirred at reflux (70 °C) under nitrogen, with progress of the reaction in the flask being monitored via GC. After 10 hours, the contents of the flask were cooled to 23 °C, and 0.15 grams of Neutralizing Agent were disposed in the flask to neutralize the Catalyst. The reaction product in the flask was filtered through a 1 micron filter to give a clear and viscous liquid. Polysiloxane Resin (A7) was isolated from the reaction product through removal of volatiles via roto-vap. Polysiloxane Resin (A7) was analyzed and is characterized below in Table 2.

Example 8: Polysiloxane Resin (A8)

200 g of Solvent (1), followed by 100 g of MQ Resin, were disposed in a 1L flask equipped with a magnetic stir-bar. 50.7 grams of Silane Compound (1), 31.6 grams of Silane Compound (3), and 0.10 grams of Catalyst were disposed in the flask. The contents of the flask were stirred at reflux (70 °C) under nitrogen, with progress of the reaction in the flask being monitored via GC. After it was determined that Silane Compounds 1 and 3 were consumed (via GC), 3.7 grams of water and 10 grams of methanol were disposed in the flask, and a Dean-Stark head was attached thereto. The contents of the flask were stirred and heated to 105 °C while collecting volatiles and replacing the volume of volatiles collected with Solvent (1). After reaching 105 °C, the contents of the flask were cooled to 23 °C, and 0.15 grams of Neutralizing Agent were disposed in the flask to neutralize the Catalyst. The reaction product in the flask was filtered through a 1 micron filter to give a clear and viscous liquid. Polysiloxane Resin (A8) was isolated from the reaction product through removal of volatiles via roto-vap. Polysiloxane Resin (A8) was analyzed and is characterized below in Table 2.

The Polysiloxane resins prepared above in Preparation Examples 1-8 are analyzed via $^{29}$Si-NMR, GPC, and DV. The results are below in Table 2.

Table 2:

| Resin: | Resin Composition by $^{29}$Si-NMR | | | | | SiOZ% | GPC (vs. PS) | | Viscosity |
|---|---|---|---|---|---|---|---|---|---|
| | W | X | $X^{MA}$ | $Y^{MA}$ | Z | (mole Si) | Mw | PDI | (cP @ 25 °C) |
| (A1) | 32.6% | 0 | 0 | 16.0% | 51.4% | 25.8% | 4,030 | 1.63 | 6,700 |

(continued)

| Resin: | Resin Composition by $^{29}$Si-NMR | | | | | SiOZ% | GPC (vs. PS) | | Viscosity |
|---|---|---|---|---|---|---|---|---|---|
| | W | X | $X^{MA}$ | $Y^{MA}$ | Z | (mole Si) | Mw | PDI | (cP @ 25 °C) |
| (A2) | 31.8% | 0 | 0 | 15.8% | 52.4% | 16.5% | 6,485 | 1.89 | 8,900 |
| (A3) | 32.5% | 0 | 0 | 15.9% | 51.6% | 13.3% | 8,850 | 2.01 | 10,500 |
| (A4) | 29.2% | 0 | 0 | 25.7% | 45.1% | 43.7% | 4,338 | 1.79 | 420 |
| (A5) | 30.8% | 8.72 | 0 | 13.3% | 47.2% | 35.3% | 4,700 | 1.75 | 1,150 |
| (A6) | 30.6% | 8.28 | 0 | 14.1% | 47.1% | 14.2% | 7,910 | 2.16 | 3,400 |
| (A7) | 30.1% | 0 | 8.80 | 14.0% | 47.1% | 33.5% | 4,590 | 1.89 | 1,350 |
| (A8) | 30.1% | 0 | 8.90 | 14.3% | 46.7% | 14.5% | 6,820 | 2.26 | 3,500 |

Examples 1-24 and Comparative Examples 1-2

Compositions were prepared with Polysiloxane Resins (A1)-(A8). The components and relative amounts utilized in each of Examples 1-24 and Comparative Examples 1-2 are below in Table 3. In Table 3, the Polysiloxane Resin, Photoinitiator, and Functional Diluent the particular species utilized is identified (based on Table 1) along with the relative amount thereof. For example, for the Photoinitiator, "(1) 2.0" indicates Photoinitiator (1) at 2 grams. In Table 3, C.E. indicates Comparative Example. Each composition is prepared by disposing the components in an amber colored dental mixing cup and mixing.

Table 3:

| Example | Polysiloxane Resin (g) | Photoinitiator (g) | Functional Diluent (g) | Condensation Catalyst (g) | Filler (g) | Viscosity at 25 °C (cP) |
|---|---|---|---|---|---|---|
| 1 | (A1) 98 | (1) 2.0 | 0 | 0 | 0 | 6,700 |
| 2 | (A1) 97 | (1) 2.0 | 0 | 1.0 | 0 | 6,700 |
| 3 | (A2) 98 | (1) 2.0 | 0 | 0 | 0 | 8,900 |
| 4 | (A2) 97 | (1) 2.0 | 0 | 1.0 | 0 | 8,900 |
| 5 | (A3) 98 | (1) 2.0 | 0 | 0 | 0 | 10,800 |
| 6 | (A3) 97 | (1) 2.0 | 0 | 1.0 | 0 | 10,800 |
| 7 | (A4) 98 | (1) 2.0 | 0 | 0 | 0 | 450 |
| 8 | (A4) 97 | (1) 2.0 | 0 | 1.0 | 0 | 450 |
| 9 | (A5) 98 | (1) 2.0 | 0 | 0 | 0 | 1,100 |
| 10 | (A5) 97 | (1) 2.0 | 0 | 1.0 | 0 | 1,100 |
| 11 | (A6) 98 | (1) 2.0 | 0 | 0 | 0 | 3,500 |
| 12 | (A6) 97 | (1) 2.0 | 0 | 1.0 | 0 | 3,500 |
| 13 | (A7) 98 | (1) 2.0 | 0 | 0 | 0 | 1,400 |
| 14 | (A7) 97 | (1) 2.0 | 0 | 1.0 | 0 | 1,400 |
| 15 | (A8) 98 | (1) 2.0 | 0 | 0 | 0 | 3,500 |
| 16 | (A8) 97 | (1) 2.0 | 0 | 1.0 | 0 | 3,500 |
| 17 | (A1) 88 | (1) 2.0 | (1) 10 | 0 | 0 | 4,800 |
| 18 | (A1) 87 | (1) 2.0 | (1) 10 | 1.0 | 0 | 4,800 |
| 19 | (A1) 86 | (1) 2.0 | (2) 10 | 1.0 | 0 | 4,800 |
| 20 | (A1) 87 | (1) 2.0 | (3) 10 | 1.0 | 0 | 4,800 |

(continued)

| Example | Polysiloxane Resin (g) | Photoinitiator (g) | Functional Diluent (g) | Condensation Catalyst (g) | Filler (g) | Viscosity at 25 °C (cP) |
|---|---|---|---|---|---|---|
| 21 | (A1) 50 | (2) 2.0 | (4) 10 | 0 | 0 | 530 |
| 22 | (A1) 50 | (2) 2.0 | (4) 10 | 1.0 | 0 | 530 |
| 23 | (A5) 50 | (3) 2.0 | 0 | 0 | 47 | 1,800 |
| 24 | (A5) 50 | (3) 2.0 | 0 | 1.0 | 47 | 1,800 |
| C.E. 1 | (A1) 99 | 0 | 0 | 1.0 | 0 | 6,700 |
| C.E. 2 | (A1) 88 | 0 | (1) 10 | 1.0 | 0 | 4,800 |

The compositions of Examples 1-24 and Comparative Examples 1-2 were utilized to prepare films. In particular, each composition was coated onto a glass substrate using a drawdown bar to give a 250 micrometer thick coating on the glass substrate. Each coating was then exposed to UV radiation (0.5 Joule dosage broadband) at 23 °C using a Fusion Systems Corporation instrument model 31983-E under nitrogen to give a cured film. Each cured film was then analyzed and, if liquid or tacky to the touch, it was considered to "fail". If the cured film was non-liquid and non-tacky to the touch, it was considered to "pass" (as reported in Table 4 below).

Some of the films formed with the compositions of Examples 1-24 and Comparative Examples 1-2 are dual cured via moisture curing following the UV curing step described above. For those coatings that are dual cured, the cured film formed following exposure to UV radiation is placed (on the glass substrate) in an environment at 23 °C and 50 % relative humidity. For those coatings that are not dual cured, to measure Skin Cure Time, the uncured layer is placed on the glass substrate in an environment at 23 °C and 50 % relative humidity. Skin Cure Time is recorded based on the time it takes for the sample to form a skin. The cured films which had a Skin Cure Time of less than 4 hours were considered to "pass", and those that did not form a skin or had a Skin Cure Time of greater than 4 hours were considered to "fail" (as reported in Table 4 below). Skin Cure Time is measured in connection with moisture curing. Thus, for films that are only UV cured and not dual cured, Skin Cure Time is separately measured based on moisture curing in the absence of any UV curing. The last column in Table 4 as to whether the films were UV cured or dual cured relates to the pencil hardness and adhesion values (described below) but not Skin Cure Time.

The cured films are analyzed for pencil hardness values in accordance with ASTM D3363-05. For those cured films that are only formed via exposure to UV radiation, the pencil hardness was determined one after curing via UV radiation. For those cured films that were subjected to dual curing, pencil hardness was measured after UV cure followed by moisture curing for six days. The results of the pencil hardness tests are set forth in Table 4 below.

The cured films are analyzed for adhesion to glass in accordance with ASTM D3359 using a Gardco PA-2000 adhesion test kit. For those cured films that are only formed via exposure to UV radiation, the adhesion to glass was determined one after curing via UV radiation. For those cured films that were subjected to dual curing, adhesion to glass was measured after moisture curing for six days. The results of the pencil hardness tests are set forth in Table 4 below. The adhesion to glass analysis involves cross-hatching the cured films. A rating of "1" means that adhesion was poor, and over 50% of the cured film was removed. A rating of "2" means that adhesion was fair, and from 5 to 50% of the cured film was removed. A rating of "3" means that adhesion was good, and that less than 5% of the cured film was removed.

Table 4:

| Example | UV Cure (pass/fail) | Skin Cure Time* (pass/fail) (time) | Pencil Hardness | Adhesion to Glass | Cure |
|---|---|---|---|---|---|
| 1 | pass | fail >6 days | 2H | 1 | UV |
| 2 | pass | pass 2h | 3H | 3 | Dual |
| 3 | pass | fail >6 days | 3H | 2 | UV |
| 4 | pass | pass 3h | 3H | 3 | Dual |
| 5 | pass | fail >6 days | 3H | 1 | UV |
| 6 | pass | fail 6h | 4H | 2 | Dual |
| 7 | pass | fail >6 days | 2H | 1 | UV |
| 8 | pass | pass 1h | 3H | 3 | Dual |

(continued)

| Example | UV Cure (pass/fail) | Skin Cure Time* (pass/fail) (time) | Pencil Hardness | Adhesion to Glass | Cure |
|---|---|---|---|---|---|
| 9 | pass | fail >6 days | 1H | 1 | UV |
| 10 | pass | pass 2h | 2H | 3 | Dual |
| 11 | pass | fail >6 days | 1H | 1 | UV |
| 12 | pass | fail 6h | 2H | 2 | Dual |
| 13 | pass | fail >6 days | 1H | 1 | UV |
| 14 | pass | pass 2h | 2H | 3 | Dual |
| 15 | pass | fail >6 days | 1H | 1 | UV |
| 16 | pass | fail 10h | 2H | 2 | Dual |
| 17 | pass | fail >6 days | 4H | 1 | UV |
| 18 | pass | pass 3h | 4H | 3 | Dual |
| 19 | pass | pass 3h | 4H | 3 | Dual |
| 20 | pass | pass 3h | 5H | 3 | Dual |
| 21 | pass | fail >6 days | 3H | 1 | UV |
| 22 | pass | pass 3h | 3H | 3 | Dual |
| 23 | pass | fail >6 days | 4H | 1 | UV |
| 24 | pass | pass 2h | 6H | 2 | Dual |
| C.E. 1 | fail | pass 2h | 4B | 3 | moisture |
| C.E. 2 | fail | pass 3h | 3B | 3 | moisture |
| *Skin Cure Time based on moisture curing | | | | | |

Example 25

A patterned film is prepared in Example 25. First, a composition is prepared by combining 8.8 grams of Polysiloxane Resin (A1), 1.0 grams Functional Diluent (1), 0.2 grams Photoinitiator (1), 0.3 grams of Silane Compound (1), and 9.7 grams of propylene glycol methyl ether acetate. The composition is mixed and passed through a 0.2 micron filter to remove solids and give a solution. The solution was spin coated on a 4" silicon wafer using a Karl Suss CT62 spin coater to give a coating on the silicon wafer. The silicon wafer and coating is pre-baked at 110 °C for 60 seconds using a rapid thermal processing (RTP) oven with a nitrogen gas purge, and then placed into a mask aligner equipped a photomask with 5-100 micron line/space. The coating on the silicon wafer was exposed to a UV-broadband source (200-380 nm) with a dosage of 1.0 J/cm$^2$ under nitrogen and followed by a post-exposure-bake at 110 °C for 60 seconds on a hotplate to form a partially cured film on the silicon wafer, the partially cured film including cured portions and uncured portions. The partially cured film on the silicon wafer was then immersed into butyl acetate for 60 seconds at RT to remove the uncured portions and form a patterned film that corresponds to the negative of the photomask. The patterned film was examined under a microscope, showing a line/space pattern with a 5 $\mu$m resolution and a 100% pattern retentivity.

Example 26

A patterned film is prepared in Example 26. First, a composition is prepared by combining 8.8 grams of Polysiloxane Resin (A5), 1.0 grams Functional Diluent (2), 0.2 grams Photoinitiator (1), 0.3 grams of Silane Compound (1), and 9.7 grams of propylene glycol methyl ether acetate. The composition is mixed and passed through a 0.2 micron filter to remove solids and give a solution. The solution was spin coated on a 4" silicon wafer using a Karl Suss CT62 spin coater to give a coating on the silicon wafer. The silicon wafer and coating is pre-baked at 110 °C for 60 seconds using a rapid thermal processing (RTP) oven with a nitrogen gas purge, and then placed into a mask aligner equipped a photomask with 5-100 micron line/space. The coating on the silicon wafer was exposed to a UV-broadband source (200-380nm) with a dosage of 1.0 J/cm$^2$ under nitrogen and followed by a post-exposure-bake at 110 °C for 60 seconds

on a hotplate to form a partially cured film on the silicon wafer, the partially cured film including cured portions and uncured portions. The partially cured film on the silicon wafer was then immersed into butyl acetate for 60 seconds at RT to remove the uncured portions and form a patterned film that corresponds to the negative of the photomask. The patterned film was examined under a microscope, showing a line/space pattern with a 5 μm resolution and a 100% pattern retentivity.

Definitions and Usage of Terms

Abbreviations used in the specification have the definitions in Table 5, below.

Table 5 - Abbreviations

| Abbreviation | Definition |
|---|---|
| cP | centiPose |
| d | day |
| Da | Daltons |
| DP | degree of polymerization |
| FTIR | Fourier Transfer Infra-Red |
| g | grams |
| GC | gas chromatography |
| GPC | gel permeation chromatography |
| HPLC | high performance liquid chromatography |
| Me | methyl |
| mg | milligrams |
| MHz | megaHertz |
| mL | milliliters |
| mm | millimeters |
| Mn | number average molecular weight as measured by GPC |
| Mp | Peak molecular weight as measured by GPC |
| mPa·s | milli-Pascal seconds |
| MS | mass spectroscopy |
| Mw | weight average molecular weight |
| Mz | Z-average molecular weight |
| NMR | nuclear magnetic resonance |
| O.D. | outer diameter |
| PDI | Polydispersity index |
| Ph | phenyl |
| ppm | parts per million |
| PTFE | polytetrafluoroethylene |
| RH | relative humidity |
| RT | room temperature of 25°C |
| s | seconds |
| SiH content | hydrogen, as silicon bonded hydrogen, as measured by $^{29}Si$ NMR |
| THF | tetrahydrofuran |

(continued)

| Abbreviation | Definition |
|---|---|
| μL | microliter |
| μm | micrometer |
| Vi | vinyl |

It is to be understood that the appended claims are not limited to express and particular compounds, compositions, or methods described in the detailed description, which may vary between particular embodiments which fall within the scope of the appended claims.

## Claims

1. A method of preparing a film, said method comprising:

   applying a composition on a substrate to give an uncured layer;
   irradiating the uncured layer; and
   exposing the uncured layer to moisture, thereby preparing the film;
   wherein the composition comprises:

   (a) a polysiloxane resin, wherein the (a) polysiloxane resin comprises the following siloxy units: $[R_3SiO_{1/2}]$, $[(OZ)_qSiO_{(4-q)/2}]$ and at least one of $[(OZ)_tR^{MA}SiO_{(3-t)/2}]$ or $[(OZ)_dRR^{MA}SiO_{(2-d)/2}]$; where: each R is independently a substituted or unsubstituted hydrocarbyl group, each $R^{MA}$ is independently an acryloxy functional group, each Z is independently H or an alkyl group, subscript q is in each occurrence a number selected from a range of 0-3, subscript t is in each occurrence a number selected from a range of 0-2, and subscript d is in each occurrence a number selected from a range of 0-1, with the proviso that the average concentration of OZ groups is at least 12 mole-percent relative to moles of silicon atoms in the (a) polysiloxane resin;
   (b) a photoinitiator; optionally
   (c) a functional diluent; and
   (d) a condensation catalyst.

2.

3. The method of claim 1, wherein the composition contains less than 30 wt.% liquid components other than (a), (b) and (c) based on the total weight of the composition.

4. The method of any one preceding claim, wherein: (i) the (a) polysiloxane resin is a liquid at 25 °C in the absence of any solvent; (ii) the composition is free from any solvent; or (iii) both (i) and (ii).

5. The method of any one preceding claim, wherein the (c) functional diluent is present in the composition, and wherein the (c) functional diluent is epoxy and/or acryloxy functional.

6. The method of claim 5, wherein the (c) functional diluent is present, and wherein the (c) functional diluent comprises a polyfunctional acrylate compound.

7. The method of any one preceding claim, wherein each $R^{MA}$ independently has the formula:

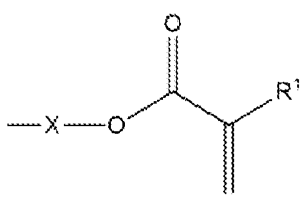

,

wherein X is a covalent bond or a divalent linking group, and $R^1$ is H or an alkyl group.

**8.** The method of any one preceding claim, further comprising disposing a photomask on the composition prior to and/or during curing such that the film comprises a patterned film including cured regions and uncured regions.

**9.** The method of claim 8, further comprising removing the uncured regions from the patterned film with a solvent.

**10.** The method of any one preceding claim, further comprising preparing the (a) polysiloxane resin (a) by reacting a silicone resin comprising $SiO_{4/2}$ siloxy units and a silane component comprising a silane compound in the presence of a catalyst to give the (a) polysiloxane resin;
wherein the silane compound has the formula $R^{MA}R^2{}_XSi(OR^2)_{3-x}$, where each $R^{MA}$ is independently an acryloxy functional group, each $R^2$ is an independently selected alkyl group having from 1 to 4 carbon atoms, and subscript x is 0 or 1.

**11.** The film formed in accordance with the method of any one preceding claim.

**12.** A composition, comprising:

(a) a polysiloxane resin, wherein the (a) polysiloxane resin comprises the following siloxy units: $[R_3SiO_{1/2}]$, $[(OZ)_qSiO_{(4-q)/2}]$ and at least one of $[(OZ)_tR^{MA}SiO_{(3-t)/2}]$ or $[(OZ)_dRR^{MA}SiO_{(2-d)/2}]$; where: each R is independently a substituted or unsubstituted hydrocarbyl group, each $R^{MA}$ is independently an acryloxy functional group, each Z is independently H or an alkyl group, subscript q is in each occurrence a number selected from a range of 0-3, subscript t is in each occurrence a number selected from a range of 0-2, and subscript d is in each occurrence a number selected from a range of 0-1, with the proviso that the average concentration of OZ groups is at least 12 mole-percent relative to moles of silicon atoms in the (a) polysiloxane resin;
(b) a photoinitiator; optionally
(c) a functional diluent; and
(d) a condensation catalyst.

## Patentansprüche

**1.** Verfahren zum Herstellen eines Films, das Verfahren umfassend:

Aufbringen einer Zusammensetzung auf ein Substrat, um eine ungehärtete Schicht zu erhalten;
Bestrahlen der ungehärteten Schicht; und
Aussetzen der ungehärteten Schicht gegenüber Feuchtigkeit, wodurch der Film hergestellt wird;
wobei die Zusammensetzung umfasst:

(a) ein Polysiloxanharz, wobei das (a) Polysiloxanharz die folgenden Siloxyeinheiten umfasst: $[R_3SiO\text{-}_{1/2}]$, $[(OZ)qSiO(_{4-q)/2}]$ und mindestens eine von $[(OZ)_tR^{MA}SiO_{(3-t)/2}]$ oder $[(OZ)_dRR^{MA}SiO_{(2-d)/2}]$; wobei: jedes R unabhängig eine substituierte oder unsubstituierte Kohlenwasserstoffgruppe ist, jedes $R^{MA}$ unabhängig eine acryloxyfunktionale Gruppe ist, jedes Z unabhängig H oder eine Alkylgruppe ist, das tiefgestellte Zeichen q bei jedem Vorkommen eine Zahl ist, die aus einem Bereich von 0-3 ausgewählt wird, das tiefgestellte Zeichen t bei jedem Vorkommen eine Zahl ist, die aus einem Bereich von 0-2 ausgewählt wird, und das tiefgestellte Zeichen d bei jedem Vorkommen eine Zahl ist, die aus einem Bereich von 0-1 ausgewählt wird, mit der Maßgabe, dass die durchschnittliche Konzentration der OZ-Gruppen mindestens 12 Molprozent relativ zu den Molen von Siliziumatomen in dem (a) Polysiloxanharz beträgt;
(b) einen Photoinitiator; optional
(c) ein funktionales Verdünnungsmittel; und
(d) einen Kondensationskatalysator.

**2.**

**3.** Verfahren nach Anspruch 1, wobei die Zusammensetzung weniger als 30 Gew.-% andere flüssige Komponenten als (a), (b) und (c) enthält, bezogen auf das Gesamtgewicht der Zusammensetzung.

**4.** Verfahren nach einem der vorstehenden Ansprüche, wobei: i) das (a) Polysiloxanharz bei 25 °C in Abwesenheit

jeglichen Lösungsmittels eine Flüssigkeit ist; (ii) die Zusammensetzung frei von jeglichem Lösungsmittel ist; oder (iii) sowohl (i) als auch (ii).

5. Verfahren nach einem der vorhergehenden Ansprüche, wobei das (c) funktionale Verdünnungsmittel in der Zusammensetzung vorhanden ist und wobei das (c) funktionale Verdünnungsmittel epoxy- und/oder acryloxyfunktional ist.

6. Verfahren nach Anspruch 5, wobei das (c) funktionelle Verdünnungsmittel vorhanden ist und wobei das (c) funktionale Verdünnungsmittel eine polyfunktionale Acrylatverbindung umfasst.

7. Verfahren nach einem der vorhergehenden Ansprüche, wobei jedes $R^{MA}$ unabhängig die folgende Formel hat:

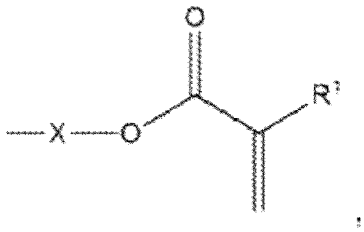

wobei X eine kovalente Bindung oder eine zweiwertige Verbindungsgruppe ist und $R^1$ H oder eine Alkylgruppe ist.

8. Verfahren nach einem der vorhergehenden Ansprüche, das außerdem das Anordnen einer Photomaske auf der Zusammensetzung vor und/oder während dem Aushärten umfasst, so dass der Film einen gemusterten Film mit ausgehärteten und ungehärteten Bereichen umfasst.

9. Verfahren nach Anspruch 8, das außerdem das Entfernen der ungehärteten Bereiche von dem gemusterten Film mit einem Lösungsmittel umfasst.

10. Verfahren nach einem der vorhergehenden Ansprüche, das außerdem das Herstellen des (a) Polysiloxanharzes (a) durch Umsetzen eines Silikonharzes, das $SiO_{4/2}$-Siloxyeinheiten umfasst, und einer Silankomponente, die eine Silanverbindung umfasst, in Gegenwart eines Katalysators umfasst, um das (a) Polysiloxanharz zu erhalten;
wobei die Silanverbindung die Formel $R^{MA}R^2_x si(OR^2)_{3-x}$ aufweist, wobei jedes $R^{MA}$ unabhängig eine acryloxyfunktionale Gruppe ist, jedes $R^2$ eine unabhängig ausgewählte Alkylgruppe ist, die 1 bis 4 Kohlenstoffatome aufweist, und das tiefgestellte Zeichen x 0 oder 1 ist.

11. Film, gebildet gemäß dem Verfahren nach einem der vorherigen Ansprüche.

12. Zusammensetzung, umfassend:

(a) ein Polysiloxanharz, wobei das (a) Polysiloxanharz die folgenden Siloxyeinheiten umfasst: $[R_3SiO_{1/2}]$, $[(OZ)_qSiO_{(4-q)/2}]$ und mindestens eine von $[(OZ)_tR^{MA}SiO_{(3-t)/2}]$ oder $[(OZ)_dRR^{MA}SiO_{(2-d)/2}]$; wobei: jedes R unabhängig eine substituierte oder unsubstituierte Kohlenwasserstoffgruppe ist, jedes $R^{MA}$ unabhängig eine acryloxyfunktionale Gruppe ist, jedes Z unabhängig H oder eine Alkylgruppe ist, das tiefgestellte Zeichen q bei jedem Vorkommen eine Zahl ist, die aus einem Bereich von 0-3 ausgewählt wird, das tiefgestellte Zeichen t bei jedem Vorkommen eine Zahl ist, die aus einem Bereich von 0-2 ausgewählt wird, und das tiefgestellte Zeichen d bei jedem Vorkommen eine Zahl ist, die aus einem Bereich von 0-1 ausgewählt wird, mit der Maßgabe, dass die durchschnittliche Konzentration der OZ-Gruppen mindestens 12 Molprozent relativ zu den Molen von Siliziumatomen in dem (a) Polysiloxanharz beträgt;
(b) einen Photoinitiator; optional
(c) ein funktionales Verdünnungsmittel; und
(d) einen Kondensationskatalysator.

## Revendications

1. Procédé de préparation d'un film, ledit procédé comprenant :

l'application d'une composition sur un substrat pour donner une couche non durcie ;
l'irradiation de la couche non durcie ; et
l'exposer de la couche non durcie à l'humidité, permettant ainsi de préparer le film ;
dans lequel la composition comprend :

(a) une résine de polysiloxane, dans lequel la résine de polysiloxane (a) comprend les motifs siloxy suivants : $[R_3SiO_{1/2}]$, $[(OZ)qSiO_{(4-q)/2}]$ et au moins l'un de $[(OZ)_tR^{MA}SiO_{(3-t)/2}]$ ou $[(OZ)_dRR^{MA}SiO_{(2-d)/2}]$ ; où : chaque R est indépendamment un groupe hydrocarbyle substitué ou non substitué, chaque $R^{MA}$ est indépendamment un groupe fonctionnel acryloxy, chaque Z est indépendamment H ou un groupe alkyle, l'indice q est dans chaque cas un nombre choisi dans une plage de 0 à 3, l'indice t est dans chaque cas un nombre choisi dans une plage de 0 à 2, et l'indice d est dans chaque cas un nombre choisi dans une plage de 0 à 1, à condition que la concentration moyenne en groupes OZ soit d'au moins 12 pour cent en moles par rapport aux moles d'atomes de silicium dans la résine de polysiloxane (a) ;
(B) un photo-initiateur ; facultativement
(c) un diluant fonctionnel ; et
(d) un catalyseur de condensation.

**2.**

**3.** Procédé selon la revendication 1, dans lequel la composition contient moins de 30 % en poids de composants liquides autres que (a), (b) et (c) sur la base du poids total de la composition.

**4.** Procédé selon l'une quelconque revendication précédente, dans lequel :
(i) la résine de polysiloxane (a) est liquide à 25 °C en l'absence de tout solvant ; (ii) la composition est exempte de tout solvant ; ou (iii) à la fois (i) et (ii).

**5.** Procédé selon l'une quelconque revendication précédente, dans lequel le diluant fonctionnel (c) est présent dans la composition, et dans lequel le diluant fonctionnel (c) est à fonctionnalité époxy et/ou acryloxy.

**6.** Procédé selon la revendication 5, dans lequel le diluant fonctionnel (c) est présent, et dans lequel le diluant fonctionnel (c) comprend un composé acrylique polyfonctionnel.

**7.** Procédé selon l'une quelconque revendication précédente, dans lequel chaque $R^{MA}$ a indépendamment la formule :

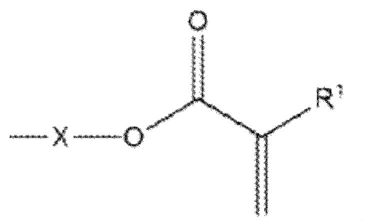
;

dans laquelle X est une liaison covalente ou un groupe de liaison divalent, et $R^1$ est H ou un groupe alkyle.

**8.** Procédé selon l'une quelconque revendication précédente, comprenant en outre la disposition d'un masque photographique sur la composition avant et/ou pendant le durcissement, de telle sorte que le film comprend un film à motifs comportant des régions durcies et des régions non durcies.

**9.** Procédé selon la revendication 8, comprenant en outre l'élimination des régions non polymérisées du film à motifs avec un solvant.

**10.** Procédé selon l'une quelconque revendication précédente, comprenant en outre la préparation de la résine polysiloxane (a) en faisant réagir une résine de silicone comprenant des motifs siloxy $SiO_{4/2}$ et un composant silane comprenant un composé silane en présence d'un catalyseur pour donner la résine de polysiloxane (a) ; dans lequel le composé silane a la formule $R^{MA}R^2_xSi(OR^2)_{3-x}$, où chaque $R^{MA}$ est indépendamment un groupe à fonctionnalité acryloxy, chaque $R^2$ est un groupe alkyle sélectionné indépendamment ayant de 1 à 4 atomes de carbone, et l'indice x vaut 0 ou 1.

**11.** Film formé conformément au procédé selon l'une quelconque revendication précédente.

**12.** Composition, comprenant :

(a) une résine de polysiloxane, dans lequel la résine de polysiloxane (a) comprend les motifs siloxy suivants : $[R_3SiO_{1/2}]$, $[(OZ)_qSiO_{(4-q)/2}]$ et au moins l'un de $[(OZ)_tR^{MA}SiO_{(3-t)/2}]$ ou $[(OZ)_dRR^{MA}SiO_{(2-d)/2}]$ ; où : chaque R est indépendamment un groupe hydrocarbyle substitué ou non substitué, chaque $R^{MA}$ est indépendamment un groupe fonctionnel acryloxy, chaque Z est indépendamment H ou un groupe alkyle, l'indice q est dans chaque cas un nombre choisi dans une plage de 0 à 3, l'indice t est dans chaque cas un nombre choisi dans une plage de 0 à 2, et l'indice d est dans chaque cas un nombre choisi dans une plage de 0 à 1, à condition que la concentration moyenne en groupes OZ soit d'au moins 12 pour cent en moles par rapport aux moles d'atomes de silicium dans la résine de polysiloxane (a) ;
(b) un photo-initiateur ; facultativement
(c) un diluant fonctionnel ; et
(d) un catalyseur de condensation.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63126727
- US 4568566 A
- WO 2008088523 A1
- US 8618233 B2